(19) Europäisches Patentamt
European Patent Office
Office européen des brevets

(11) EP 1 783 906 A2

(12) EUROPEAN PATENT APPLICATION

(43) Date of publication:
09.05.2007 Bulletin 2007/19

(51) Int Cl.:
*H03H 17/02* (2006.01) *G01G 23/10* (2006.01)

(21) Application number: 06022754.3

(22) Date of filing: 31.10.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 02.11.2005 JP 2005319313

(71) Applicant: ISHIDA CO., Ltd.
Kyoto-shi,
Kyoto 606-8392 (JP)

(72) Inventors:
- Aikawa, Naoyuki
Tokyo 161-0032 (JP)
- Wakasa, Yukio c/o Ishida Co.,Ltd.
Ritto-shi,
Shiga 520-3026 (JP)
- Nakatani, Makoto c/o Ishida Co.,Ltd.
Ritto-shi,
Shiga 520-3026 (JP)

(74) Representative: Altenburg, Udo et al
Patent- und Rechtsanwälte
Bardehle . Pagenberg . Dost . Altenburg . Geissler
Postfach 86 06 20
81633 München (DE)

# (54) Noise eliminating apparatus, weight measurement apparatus, method of eliminating noise, and method of designing digital filter

(57) A filter coefficient calculator (6) of a weight measurement apparatus calculates filter coefficients using a predetermined arithmetic expression and outputs them to a signal processor (5). The signal processor (5) carries out a filtering process on a weighing signal (D6) using the filter coefficients. The arithmetic expression includes a spectrum parameter specifying a band position of an attenuation band where attenuation must be locally enhanced. A user can input a value of the parameter via a data entry part (7). Each band is specified by the spectrum parameter not as the lowest limit value of a normalized angular frequency, but as the amount of deviation (the amount of displacement) from its center frequency.

FIG. 1

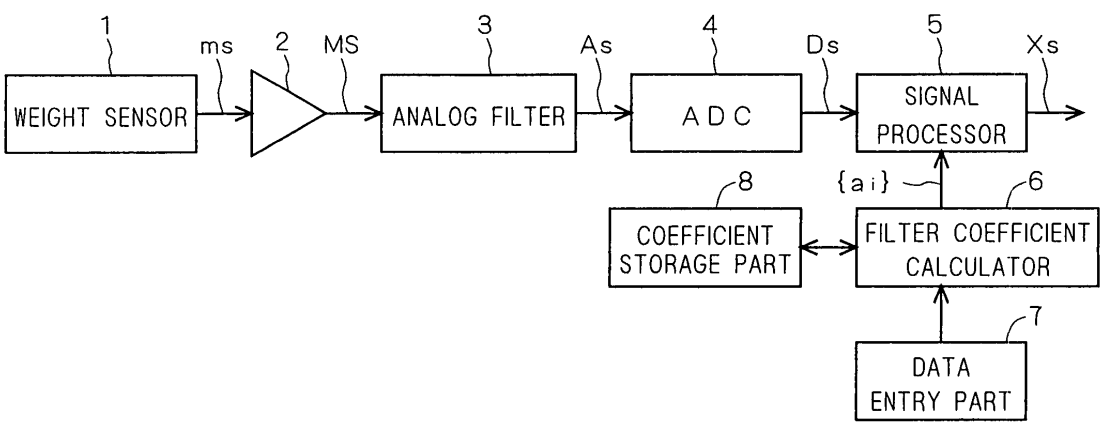


EP 1 783 906 A2

Printed by Jouve, 75001 PARIS (FR)

## Description

BACKGROUND OF THE INVENTION

Field of the Invention

The present invention relates to a filtering technique carried out by using a digital filter.

Description of the Background Art

A weight measurement apparatus for measuring a weight of an article typically employs a weight sensor such as a strain gauge load cell or a force balance. The weight sensor has a natural frequency which is subject to a total weight of a weight of an article and a tare thereof. When external vibration at frequencies in a band including the natural frequency acts upon a weight measurement system, external vibration at a frequency close to the natural frequency is amplified, to work as a vibration noise, which then emerges in a weighing signal output from the weight sensor. It is noted that such a vibration noise will be hereinafter referred to as a "natural frequency noise" throughout the present specification.

Also, in measuring a load of a transfer system, a noise caused due to vibration of a rotation system such as a motor for driving a conveyor belt or a transfer roller, or an electrical noise associated with a commercial power supply, works as a vibration noise which is superimposed on a weighing signal.

A weight measurement apparatus developed in recent days has employed a digital filter for eliminating such a vibration noise as described above which is contained in a weighing signal. A digital filter is relatively impervious to influence of aging or an environment, and filtering characteristics thereof can be relatively easily altered. Among various types of digital filters, a finite impulse response (FIR) filter has been preferably employed in view of its excellent stability.

As described above, a natural frequency of a weight sensor is subject to an article weight and a tare. Thus, if an article weight or a tare is changed, it results in change in a frequency of a natural frequency noise associated with the weight sensor. Formerly, change in frequency of a natural frequency noise caused due to change in article weight was negligible because a tare, e.g., a weight of a conveyor, was dominant. However, in recent days, there has been arisen a demand for accurate measurement of a weight of a light article, which involves reduction of a tare. For this reason, such change in frequency of a natural frequency noise caused due to change in article weight has become too significant to neglect. On the other hand, a frequency of a vibration noise associated with a motor or a transfer roller is changed in accordance with specifications of a transfer system such as a transfer speed, for example. Hence, it is desired to achieve a digital filter which is capable of surely eliminating a vibration noise in spite of change in frequency of the vibration noise which occurs due to change in type or size of an article under measurement, or change in specifications of a transfer system.

In accordance with the conventional practices, a digital filter formed of multistage moving average filters is employed in order to surely eliminate a vibration noise contained in a weighing signal, as taught in Japanese Patent Publication No. 6-21814 (hereinafter referred to as "JP 6-21814").

More specifically, JP 6-21814 teaches a method in which respective moving average values of the multistage moving average filters are differentiated from one another to provide a plurality of notches in a frequency range within which a frequency of a vibration noise would be changed, thereby surely eliminating the vibration noise.

Additionally, an example of a method of designing an FIR filter is described in "Design of FIR Transmitter and Receiver Filters for Data Communication System" by Naoyuki Aikawa et al. in Transaction of IEICE, Vol. J79-A, No. 3, March 1996, pages 608-615, which shows a technique using successive projections method.

According to the method shown in JP 6-21814, a frequency range within which a frequency of a vibration noise would be changed is presumed and the number of stages of the moving average filters is determined in accordance with the frequency range as presumed, in a step of designing a digital filter. As such, in a situation where the frequency of the vibration noise falls outside the presumed frequency range for some reason such as addition of a specification after designing the digital filter, it is required to design a digital filter all over again.

In this regard, to initially design a digital filter which allows for addition of a specification in a weight measurement apparatus requires preparing numerous multistage moving average filters, which results in increase of a circuit scale of the digital filter.

On the other hand, as an alternative to the method taught in JP 6-21814, there has been proposed a method in which a plurality of filter coefficients representing different attenuation characteristics are previously stored. According to this method, each time a frequency of a vibration noise is changed due to change in specifications or the like, one of the stored filter coefficients is retrieved in accordance with a new frequency of the vibration noise after the change, to be used. However, this alternative requires previously storing numerous filter coefficients in order to surely eliminate a vibration noise at a wide range of frequencies, which results in increase of a circuit scale of a memory for storing the filter coefficients.

## SUMMARY OF THE INVENTION

It is an object of the present invention to provide a filtering technique which makes it possible to easily and appropriately eliminate a noise without increasing a scale of a circuit necessary for a filtering process even if a noise frequency is liable to be changed.

In an aspect of the present invention, a noise eliminating apparatus includes: a signal processor for carrying out a filtering process on a digital signal by using variable filter coefficients; and a filter coefficient calculator for calculating the filter coefficients using a predetermined arithmetic expression and outputting the filter coefficients to the signal processor. The arithmetic expression includes parameters specifying respective band positions of a plurality of attenuation bands where attenuation is to be enhanced locally in a stopband of amplitude characteristics of the filtering process, and the filter coefficient calculator substitutes input values of the parameters into the arithmetic expression, to change the filter coefficients so that the plurality of attenuation bands are independently movable to respective desired band positions specified by the parameters.

The present invention is also intended for a method of eliminating a noise.

The filter coefficients can be changed by using the parameter specifying the band position of the attenuation band which is physical and thus easy to grasp. As such, even when a frequency which must be attenuated is changed, it is possible to easily move the attenuation band by referring to information about a new frequency which must be attenuated. Accordingly, a frequency of a noise, which is liable to be changed, can be filtered out easily and appropriately. Further, since the filter coefficients are obtained by the arithmetic expression, there is no need of preparing multistage filters or previously storing filter coefficients representing different characteristics. This makes it possible to reduce a scale of a circuit necessary for the filtering process and to thus provide a low cost noise eliminating apparatus to users. Moreover, since a plurality of attenuation bands can be specified, a plurality of causes causing a big noise and varying can be dealt with appropriately.

In another aspect of the present invention, a weight measurement apparatus includes: a measurer for detecting a weight of an object; and the noise eliminating apparatus mentioned above for carrying out a filtering process on a digital signal which is obtained as a measurement result by the measurer.

A weight measurement apparatus capable of filtering a noise appropriately can be obtained.

The present invention is also intended for a method of designing a digital filter in which respective band positions of a plurality of attenuation bands where attenuation is to be enhanced locally in a stopband of amplitude characteristics are variable. This method includes the steps of: (a) calculating a plurality of sequences of reference filter coefficients based on reference amplitude characteristics of the digital filter; (b) approximating filter coefficients of the digital filter using a predetermined arithmetic expression including parameters specifying the respective band positions of the plurality of attenuation bands, based on the plurality of sequences of the reference filter coefficients; and (c) calculating the filter coefficients using the predetermined arithmetic expression. The step (c) includes the step of (c-1) substituting values of the parameters into the predetermined arithmetic expression, to change the filter coefficients, and the plurality of attenuation bands are independently moved to respective desired band positions specified by the parameters by performing the step (c-1).

The filter coefficients can be changed by using the parameter specifying the band position of the attenuation band which is physical and thus easy to grasp. As such, even when a frequency which must be attenuated is changed, it is possible to easily move the attenuation band by referring to information about a new frequency which must be attenuated. Accordingly, a frequency of a noise, which is liable to be changed, can be filtered out easily and appropriately. Further, since the filter coefficients are obtained by the arithmetic expression, there is no need of preparing multistage filters. This makes it possible to reduce a scale of a circuit of the digital filter. Moreover, since a plurality of attenuation bands can be specified, a plurality of causes causing a big noise and varying can be dealt with appropriately.

Preferably, each of the parameters is given as the amount of displacement from a center frequency in a range where a corresponding attenuation band among the plurality of attenuation bands is to vary.

A plurality of parameters can be approximated equally in designing a filter, which in turn allows the design of a desired filter.

These and other objects, features, aspects and advantages of the present invention will become more apparent from the following detailed description of the present invention when taken in conjunction with the accompanying drawings.

## BRIEF DESCRIPTION OF THE DRAWINGS

Fig. 1 is a block diagram illustrating a structure of a weight measurement apparatus according to conventional art of the present invention.

Fig. 2 is a graph showing amplitude characteristics of a filtering process in a signal processor according to the conventional art of the present invention.

Fig. 3 is a flow chart illustrating operations for measuring a weight in the weight measurement apparatus according to the conventional art of the present invention.

Figs. 4 through 8 are graphs showing amplitude characteristics of an optimum filter.

Fig. 9 shows values of coefficients $g_{i,j}$.

Figs. 10 through 13 are graphs showing amplitude characteristics of the filtering process in the signal processor according to the conventional art of the present invention.

Fig. 14 shows respective maximum errors of the optimum filter and a filter used in the signal processor according to the conventional art of the present invention.

Fig. 15 shows a method of defining spectrum parameters according to a preferred embodiment of the present invention.

Fig. 16 shows amplitude characteristics when an FIR filter with fixed coefficients is designed.

Figs. 17 through 26 show variations in amplitude characteristics when spectrum parameters $\delta_1$ and $\delta_2$ are varied.

DESCRIPTION OF THE PREFERRED EMBODIMENTS

<Description of Conventional Art of the Present Invention>

Before describing a preferred embodiment according to the present invention, a weight measurement apparatus serving as conventional art of the present invention will be described. The conventional art is disclosed in Japanese Patent Application Laid-Open No. 2004-150883 filed by the applicant of the present invention.

Fig. 1 is a block diagram illustrating the structure of the weight measurement apparatus according to the conventional art. As illustrated in Fig. 1, the weight measurement apparatus according to the conventional art includes a weight sensor 1 such as a strain gauge load cell or a force balance, an amplifier 2, an analog filter 3, an A/D converter (which will be hereinafter referred to as an "ADC") 4, a signal processor 5, a filter coefficient calculator 6, a data entry part 7 and a coefficient storage part 8.

The weight sensor 1 detects a weight of an object under measurement, which is notified by a weight measurement system, and outputs a result of the detection to the amplifier 2, as a measurement signal ms. The amplifier 2 amplifies the measurement signal ms input by the weight sensor 1, and outputs it to the analog filter 3, as an amplified signal MS. The analog filter 3 removes an unnecessary higher frequency component from the amplified signal MS, to output a resultant signal as an analog signal As. The ADC 4 samples the analog signal As output from the analog filter 3 at predetermined sampling intervals, to generate a digital signal which is quantized to be represented by the predetermined number of bits and then output the digital signal to the signal processor 5, as a weighing signal Ds.

The signal processor 5 carries out a filtering process on the weighing signal Ds input by the ADC 4, using a FIR filter, and outputs a result of the filtering process to a microcomputer (not illustrated), as a signal Xs. Then, the microcomputer calculates the weight of the object based on the signal Xs and displays a result of the calculation on a display part (not illustrated). It is noted that generally, a frequency response $H(e^{j\omega})$ of a 2Nth order FIR filter is expressed by the following equation (1):

$$H(e^{j\omega}) = \sum_{i=0}^{N} a_i \cos i\omega \qquad \ldots \qquad \text{Equation (1).}$$

In the equation (1), "$a_i$" (i =0, 1, 2, ..., N) represents filter coefficients. Also, "ω" represents a normalized angular frequency, that is, an angular frequency normalized by using a sampling frequency used for a filtering process on data. In the conventional art, an angular frequency which is normalized by using a sampling frequency used for the filtering process on data carried out by the signal processor 5 corresponds to the normalized angular frequency represented by "ω". It is noted that the terms "normalized angular frequency" will hereinafter mean such an angular frequency as defined above, i.e., an angular frequency which is normalized by using a sampling frequency, throughout the present specification.

Fig. 2 is a graph showing an example of amplitude characteristics of the filtering process carried out by the signal processor 5. As shown in Fig. 2, the FIR filter used in the signal processor 5 is a low pass filter, so that an attenuation band 9 where attenuation is locally great is present in a stopband of the amplitude characteristics. The weight measurement apparatus according to the conventional art can function to change a band position of the attenuation band 9. More specifically, the weight measurement apparatus can function to move the attenuation band 9 to a higher frequency position or a lower frequency position. It is noted that the terms "attenuation band" will hereinafter mean a band where attenuation must be enhanced locally in a stopband, like the attenuation band 9 shown in Fig. 2, throughout the present specification.

The filter coefficient calculator 6 calculates sequences $\{a_i\}$ of the filter coefficients $a_i$ in the above equation (1) using the following equation (2), and outputs a result of the calculation to the signal processor 5:

$$a_i = b_i(x) = \sum_{j=0}^{M} g_{i,j}x^{M-j} = g_{i,0}x^M + g_{i,1}x^{M-1} + \ldots + g_{i,M-1}x + g_{i,M} \quad \ldots \text{Equation (2).}$$

In the equation (2), "$g_{i,j}$" (j=0, 1, 2, ... M) represents coefficients. Also, "x" represents a parameter specifying a band position of an attenuation band, and a value substituted for x is varied in accordance with the position of the attenuation band. As shown in the equation (2), the filter coefficients a; are expressed by a polynomial including a plurality of terms for the parameter x. Then, by substituting the equation (2) into the equation (1), the frequency response H ($e^{j\omega}$) can be expressed by the following equation (3):

$$H(e^{j\omega}) = \sum_{i=0}^{N} \sum_{j=0}^{M} g_{i,j}x^{M-j}\cos i\omega \ldots \qquad \text{Equation (3).}$$

The coefficient storage part 8 is a ROM (Read-Only Memory), for example, and previously stores values of the coefficients $g_{i,j}$. The values of the coefficients $g_{i,j}$ are read out from the coefficient storage part 8 by the filter coefficient calculator 6.

The data entry part 7 is a keyboard, for example, and receives a value of the parameter x which is input by a user external to the weight measurement apparatus. The data entry part 7 then outputs the received value of the parameter x to the filter coefficient calculator 6.

Next, operations for measuring a weight of an object in the weight measurement apparatus according to the conventional art will be described with reference to a flow chart in Fig. 3.

As illustrated in Fig. 3, power is supplied to the weight measurement apparatus in a step s1. In a subsequent step s2, the filter coefficient calculator 6 reads out the values of the coefficients $g_{i,j}$ from the coefficient storage part 8, and further reads out an initial value of the parameter x which is previously stored therewithin.

Then, the filter coefficient calculator 6 substitutes the values of the coefficients $g_{i,j}$ and the initial value of the parameter x into the equation (2), to calculate one sequence $\{a_i\}$ of the filter coefficients and output it to the signal processor 5, in a step s3. As a result, a band position of an attenuation band in filtering characteristics exhibited in the signal processor 5 is set to an initial position specified by the parameter x. It is noted that the filter coefficients $a_i$ can be calculated promptly because the equation (2) for calculating the filter coefficients $a_i$ are expressed by a polynomial.

Thereafter, in a step s4, the signal processor 5 carries out a filtering process on the weighing signal Ds using the one sequence $\{a_i\}$ of the filter coefficients which has been calculated in the step s3. Further, the signal processor 5 outputs a result of the filtering process to the microcomputer, as the signal Xs, and the microcomputer displays the weight of the object on the display part such as a CRT.

Then, upon receipt of a new value of the parameter x input by a user of the weight measurement apparatus, the data entry part 7 outputs the received new value to the filter coefficient calculator 6 in a step s5.

As described above, change in type of an object or the like results in change in a natural frequency of the weight sensor 1 and thus change in frequency of a natural frequency noise contained in the weighing signal Ds. In this connection, a user of the weight measurement apparatus inputs a value of the parameter x specifying a position of a band including a new natural frequency after the change, in order to surely eliminate the natural frequency noise, in the step s5. For example, information about the natural frequency of the weight sensor 1 for each type of object under measurement is previously prepared, and the user inputs a value of the parameter x to the data entry part 7 while referring to the information, each time the type of the object is changed.

It is noted that though the structure described above is configured so as to require input of a value of the parameter x to the data entry part 7, the structure may alternatively be configured so as to allow a value of the parameter x to be automatically determined. For example, this alternative is possible in a weight measurement apparatus such as a weight checker in which a frequency which must be attenuated can be determined by determining a speed of a conveyor. Further alternatively, automatic determination of a value of the parameter x can be accomplished by carrying out frequency analysis by means of the FFT of a vibration waveform of the measurement signal or the like and then detecting a portion of the waveform which has the greatest amplitude. The structure may be configured so as to implement this procedure.

Turning back to the flow chart, subsequently to the step s5, the filter coefficient calculator 6 substitutes the new value of the parameter x which is received from the data entry part 7 into the equation (2), and changes the one sequence $\{a_i\}$ of the filter coefficients to output a new sequence $\{a_i\}$ to the signal processor 5, in a step s6. As a result, the attenuation band in the filtering characteristics exhibited in the signal processor 5 is moved from the initial band position to a band position specified by the new value of the parameter x. Then, in a step s7, the signal processor 5 carries out a filtering process using the new sequence $\{a_i\}$ of the filter coefficients obtained in the step s6, and outputs a result of the filtering process as the signal Xs.

If there is a need of changing again the position of the attenuation band, the user inputs a further new value of the parameter x to the data entry part 7. Then, the steps s6 and s7 are performed, so that the attenuation band is moved to a band position newly specified by the further new value of the parameter x.

As is made clear from the foregoing description, in the weight measurement apparatus according to the conventional art, the filter coefficients $a_i$ can be changed by using the parameter x specifying a band position of an attenuation band which is physical and thus easy to grasp. Accordingly, even when a frequency which must be attenuated in the signal processor 5 is changed due to change in the natural frequency of the weight sensor 1 or the like, it is possible to easily move the attenuation band by referring to information about a new frequency which must be attenuated. Therefore, a frequency of a noise in the weighing signal Ds, which is liable to be changed, can be filtered out easily and appropriately.

Moreover, as shown in the equation (2), the filter coefficients $a_i$ are obtained by a predetermined arithmetic expression. This eliminates a need of preparing multistage filters which are required in the method of JP 6-21814 described in the Background section, and a need of previously storing filter coefficients representing different characteristics. Therefore, a scale of a circuit necessary for a filtering process can be reduced, which makes it possible to provide a low cost weight measurement apparatus to users.

Next, processes for determining values of the coefficients $g_{i,j}$ will be described. First, ideal amplitude characteristics $M(e^{j\omega}, \phi)$, in other words, reference amplitude characteristics, and a weight function $W(e^{j\omega}, \phi)$ of a FIR filter in which a band position of an attenuation band is variable are provided by the following equations (4) and (5):

$$M(e^{j\omega}, \phi) = \begin{cases} 1 & 0 \le |\omega| \le \omega_p \\ 0 & \omega_s \le |\omega| \le \varphi \\ 0 & \varphi \le |\omega| \le \varphi + w \\ 0 & \varphi + w \le |\omega| \le \pi \end{cases} \quad \ldots \text{Equation (4).}$$

$$W(e^{j\omega}, \phi) = \begin{cases} 1 & 0 \le |\omega| \le \omega_p \\ 1 & \omega_s \le |\omega| \le \varphi \\ 10 & \varphi \le |\omega| \le \varphi + w \\ 1 & \varphi + w \le |\omega| \le \pi \end{cases} \quad \ldots \text{Equation (5).}$$

In the equations (4) and (5), "$\omega_p$" represents a normalized angular frequency of an edge of a passband, "$\omega_s$" represents a normalized angular frequency of an edge of a stopband, "w" represents a width of an attenuation band, and "$\phi$" represents a parameter controlling a band position of an attenuation band. Among those, a relationship $\omega_s < \phi < \pi - w$ is maintained.

According to the conventional art, an attenuation band in the reference amplitude characteristics extends over an angular frequency range (which will be hereinafter simply referred to as a "frequency range") from $\phi$ to $(\phi + w)$, and a band position of the attenuation band is specified depending on a value of the parameter $\phi$, as shown in the above equation (4). The band position of the attenuation band in the reference amplitude characteristics will hereinafter be referred to as a "reference band position" throughout the present specification.

Subsequently, an optimum filter is designed for each of values $\phi_k$ (k = 0, 1, 2, ... K) which is to be substituted for the parameter $\phi$. A larger value of "k" indicates a large value $\phi_k$. In the conventional art, the optimum filter is designed through successive projections method. Detailed description thereof will be made below.

Given that the filter coefficients a; provided when the values $\phi_k$ are substituted for the parameter $\phi$ are filter coefficients $a_{i,k}$, a frequency response $H(e^{j\omega}, \phi_k)$ of a digital filter provided when each of the values $\phi_k$ is substituted for the parameter $\phi$ is expressed by the following equation (6):

$$H(e^{j\omega}, \phi_k) = \sum_{i=0}^{N} a_{i,k} \cos i\omega \qquad \text{... Equation (6).}$$

Then, in order to obtain the filter coefficients $a_{i,k}$ through successive projections method, an error $e(\omega)$ found in an n-time calculation of repeated calculations is expressed by the following equation (7):

$$e(\omega) = \left|M(\omega) - \sum_{i=0}^{N} a^n{}_{i,k} \cos i\omega\right| \qquad \text{... Equation (7).}$$

In the equation (7), "$M(\omega)$" represents the reference amplitude characteristics $M(e^{j\omega}, \phi)$. It is noted that a superscript "n" of the filter coefficients $a_{i,k}$ represents not an exponent, but the number of repetitions.

Now, given that a frequency at which specifications are most slightly met is "$\omega_M$" and a tolerance relative to the reference amplitude characteristics is "$\lambda(\omega)$", the following equation (8) is established:

$$|e(\omega_M) - \lambda(\omega_M)| = \max_{\omega \in all} |e(\omega) - \lambda(\omega)| \qquad \text{... Equation (8).}$$

Given that a tolerance obtained when the weight function $W(e^{j\omega}, \phi)$ is equal to 1 is "$\delta$", the tolerance $\lambda(\omega)$ is expressed by the following equation (9):

$$\lambda(\omega) = \delta / W(\omega) \qquad \text{... Equation (9).}$$

In the equation (9), "$W(\omega)$" represents the weight function "$W(e^{j\omega}, \phi)$".

As shown in the equations (5) and (9), a tolerance relative to the attenuation band in the reference amplitude characteristics which is employed in designing the optimal filter is set to one-tenth of a tolerance relative to the other bands in the reference amplitude characteristics, depending on the weight function.

The filter coefficients are updated in successive projections method by using the following equation (10):

$$a^{n+1}_{i,k} = \begin{cases} a^n_{i,k} - \dfrac{\{\lambda(\omega_M) - e_M\}\cos(i\omega_M)\,sign(e_M)}{\sum_{i=0}^{N} \cos^2(i\omega_M)} & if \quad e_M > \lambda(\omega_M) \\ a^n_{i,k} & if \quad e_M \le \lambda(\omega_M) \end{cases} \qquad \text{... Equation (10).}$$

In the equation (10), "$e_M$" is equal to "$e(\omega_M)$".

The filter coefficients are repeatedly updated using the above equation (10) until they converge, in other words,

until $e_M \leqq \lambda(\omega_M)$, to thereby obtain optimum filter coefficients $a_{i,k}$.

In this manner, K sequences $\{a_{i,0}\}, \{a_{i,1}\}, ..., \{a_{i,K}\}$ of the filter coefficients $a_{i,k}$ are obtained based on respective reference amplitude characteristics which are obtained when $\phi_0, \phi_1, ... \phi_k$ are substituted for the parameter $\phi$, as well as respective values of the weight function which are obtained when $\phi_0, \phi_1, ... \phi_k$ are substituted for the parameter $\phi$. The optimum filter coefficients $a_{i,k}$ obtained based on the reference amplitude characteristics and the weight function will serve as reference filter coefficients $a_{i,k}'$ (k = 0, 1, 2, ... K).

Next, least square approximation is carried out on the reference filter coefficients $a_{i,k}'$ using an Mth order polynomial $b_i(x)$ in the equation (2), to determine values of the coefficients $g_{i,j}$.

To this end, a value $b_0(\phi_k)$ obtained when any of the values $\phi_k$ is substituted for the parameter x and the filter coefficients $a_{0,k}'$ are dealt with, first. The following equation (11) is provided:

$$S = \sum_{k=0}^{K} (b_0(\phi_k) - a_{0,k}')^2 \quad \text{... Equation (11).}$$

In order to carry out least square approximation on the reference filter coefficients $a_{i,k}'$ using a polynomial $b_i(x)$, to calculate a vector $B_0 = [g_{0,0}\, g_{0,1} \cdots g_{0,M}]^T$ which allows "S" in the above equation (11) to be minimized is statistically preferable, as is well known. A specific procedure for the calculation is to solve simultaneous equations given by the following equation (12) which shows conditions for obtaining maximum and minimum values, for "$g_{0,0}, g_{0,1}, ..., g_{0,M}$":

$$\frac{\partial S}{\partial g_{0,0}} = 0,\ \frac{\partial S}{\partial g_{0,1}} = 0,\ ...,\ \frac{\partial S}{\partial g_{0,M}} = 0 \quad \text{... Equation (12).}$$

Then, expression of the equation (12) using normal equations is as follows:

$$(X^T X) B_0 = X^T A_{0,k} \quad \text{... Equation (13)}$$

$$X = \begin{bmatrix} \varphi_0^M & \varphi_0^{M-1} & \cdots & \varphi_0 & 1 \\ \varphi_1^M & \varphi_1^{M-1} & \cdots & \varphi_1 & 1 \\ \vdots & \vdots & & \vdots & \vdots \\ \varphi_K^M & \varphi_K^{M-1} & \cdots & \varphi_K & 1 \end{bmatrix} \quad \text{... Equation (14)}$$

$$A_{0,k} = [a_{0,0}'\ a_{0,1}'\ \ldots\ a_{0,k}']^T \quad \text{... Equation (15).}$$

A matrix X for the equation (12) is obtained based on the values $\phi_k$, and a vector $A_{0,k}$ is obtained based on the reference filter coefficients $a_{i,k}'$ which have been previously obtained through successive projections method. Accordingly, both "$(X^T X)$" on the left side and "$(X^T A_{0,k})$" on the right side of the equation (13) can be obtained, so that the vector $B_0$ can be obtained.

A value $b_1(\phi_k)$ and the reference filter coefficients $a_{1,k}'$, a value $b_2(\phi_k)$ and the reference filter coefficients $a_{2,k}'$, ..., and a value $b_N(\phi_k)$ and the reference filter coefficients $aN,_k'$ are dealt with by following the same procedures as described above, to obtain a vector $B_i = [g_{i,0} g_{i,1} \cdots g_{i,M}]^T$.

According to the conventional art, values obtained in the foregoing manner are employed as values of the coefficients $g_{i,j}$ in the equation (2), to thereby allow the parameter x to specify a band position of an attenuation band.

Also, in the conventional art, when the reference amplitude characteristics is defined as expressed by the equation (4), a value of the parameter x that a user can input should be within a range from $\phi_0$ to $\phi_K$, inclusive ($\phi_0 \leqq x \leqq \phi_K$). For example, if the user inputs the value $\phi_0$ as a value of the parameter x to the data entry part 7, a band position provided by a frequency range from $\phi_0$ to ($\phi_0$ + w) is specified as a band position of the attenuation band. If the user inputs the value $\phi_K$ as a value of the parameter x to the data entry part 7, a band position provided by a frequency range from $\phi_K$ to ($\phi_K$ + w) is specified as a band position of the attenuation band.

As described above, the user can specify a band position of an attenuation band within a frequency range from a reference band position in the reference amplitude characteristics provided when $\phi = \phi_0$ to another reference band position in the reference amplitude characteristics provided when $\phi = \phi_K$, by means of the parameter x. Also, by previously preparing a table establishing a correspondence between a value of the parameter x and a band position of an attenuation band, the user can easily specify a desired band position.

Additionally, the weight function $W(e^{j\omega}, \phi)$ determines a weight of a tolerance used in designing the optimum filter for each frequency range, as described above. Accordingly, attenuation in the attenuation band in the filtering characteristics exhibited in the signal processor 5 is specified depending on a value of the weight function $(e^{j\omega}, \phi)$ provided when a relationship $\phi \leqq |\omega| \leqq \phi + w$ is maintained. In the conventional art, attenuation in the attenuation band which is provided by the signal processor 5 is set to ten times of attenuation in the other bands in the stopband, as shown in the equation (5).

Next, specific description will be made about how a band position of an attenuation band is changed on an axis of frequency depending on a value of the parameter x, by substituting specific numerical values for the coefficients $g_{i,j}$.

First, conditions are laid down as follows, for example.

$$\omega_p = 0.05\pi \qquad \text{... Equation (16)}$$

$$\omega_s = 0.2\pi \qquad \text{... Equation (17)}$$

$$w = 0.1\pi \qquad \text{... Equation (18)}$$

$$\delta = 0.042 \qquad \text{... Equation (19)}$$

$$N = 10 \qquad \text{... Equation (20)}$$

Also, assume that $\phi$ is in a range from 0.3 $\pi$ to 0.4 $\pi$, inclusive ($0.3\pi \leqq \phi \leqq 0.4\pi$) and that discrete values obtained by dividing the range into 11 equal parts correspond to the values $\phi_k$(k = 0,1, ..., 10). Then, $\phi_0$ is 0.3 $\pi$ ($\phi_0 = 0.3\pi$), $\phi_1$ is 0.31 $\pi$ ($\phi_1 = 0.31\pi$), $\phi_2$ is 0.32 $\pi$ ($\phi_2 = 0.32\pi$), ..., and $\phi_{10}$ is 0.4 $\pi$ ($\phi_{10} = 0.4\pi$). Accordingly, a range of a value which can be substituted for the parameter x is $0.3\pi \leqq X \leqq 0.4\pi$.

Figs. 4 through 8 are graphs showing amplitude characteristics of an optimum filter having the reference filter coefficients $a_{i,k}$' obtained under the above-noted conditions. Figs. 4 through 8 show the amplitude characteristics which are observed in situations where $\phi$ is $\phi_0$, $\phi_2$, $\phi_5$, $\phi_8$, and $\phi_{10}$, respectively. The reference amplitude characteristics is assumed with respect to each of the situations shown in Figs. 4 through 8, respectively, and a solid line 10 in each of the graphs denotes a reference band position (within a frequency range from $\phi$ to ($\phi$ +w)) of each reference amplitude characteristics.

Referring to Figs. 4 through 8, it is appreciated that a band position of the attenuation band 9 in the optimum filter is changed in accordance with a value of the parameter $\phi$, and that an equal ripple property is found in bands other than the attenuation band 9 in the stopband.

Next, the reference filter coefficients $a_{i,k}$' obtained under the above-noted conditions are approximated by a fifth order polynomial (M = 5), to determine values of the coefficients $g_{i,j}$, which are shown in Fig. 9.

Figs. 10 through 13 are graphs showing amplitude characteristics of a filtering process which is carried out by the signal processor 5 while the values shown in Fig. 9 are employed as values of the coefficients $g_{i,j}$ in the equation (2). Specifically, Fig. 10 shows characteristics exhibited when the values $\phi_0$, $\phi_1$, ... and $\phi_{10}$ are substituted for the parameter x. Figs. 11, 12 and 13 show characteristics exhibited when 0.305 $\pi$, 0.355 $\pi$ and 0.395 $\pi$ are substituted for the parameter x, respectively. The reference amplitude characteristics is assumed with respect to each of situations shown in Figs. 11, 12 and 13, respectively, and the solid line 10 in each of Figs. 11, 12 and 13 denotes a reference band position (within a frequency range from $\phi$ to ($\phi$ + w)) of each reference amplitude characteristics in the same manner as in Figs. 4 through 8.

Referring to Fig. 11, when 0.305 $\pi$ is substituted for the parameter x, attenuation becomes great in a frequency range from about 0.305 $\pi$ to 0.405 $\pi$ (a range denoted by the solid line 10). Also, referring to Fig. 12, when 0.355 $\pi$ is substituted for the parameter x, attenuation becomes great in a frequency range from about 0.355 $\pi$ to 0.455 $\pi$. Then, turning to Fig. 13, when 0.395 $\pi$ is substituted for the parameter x, attenuation becomes great in a frequency range from about 0.395 $\pi$ to 0.495 $\pi$.

It is appreciated from Figs. 11, 12 and 13 that attenuation becomes great locally in a band position specified by the parameter x. Further, it is appreciated from Figs. 10 through 13 that attenuation in the attenuation band 9 is about ten times (20 dB) greater than that in bands other than the attenuation band in the stopband.

Fig. 14 shows a maximum error in the amplitude characteristics of the optimum filter having the reference filter coefficients $a_{i,k}$' obtained under the above-noted conditions and a maximum error in the amplitude characteristics of the filter used in the signal processor 5. The filter used in the signal processor 5 corresponds to a filter having the filter coefficients $a_i$ which are approximated by an Mth order polynomial $b_i(x)$ including the coefficients $g_{i,j}$ having the values shown in Fig. 9. It is noted that frequency ranges AR1 through AR4 in Fig. 14 are a frequency range of $0 \leqq |\omega| \leqq \omega_p$, a frequency range of $\omega_s \leqq |\omega| \leqq \phi_k$, a frequency range of $\phi_k \leqq |\omega| \leqq \phi_k + w$, and a frequency range of $\phi_k + w \leqq |\omega| \leqq \pi$, respectively.

As shown in Fig. 14, the respective maximum errors of the optimum filter and the filter used in the signal processor 5 have the substantially same value as a result of approximating the filter coefficients by a fifth order polynomial based on one sequence $\{a_{i,k}'\}$ of the reference filter coefficients.

As is made clear from the foregoing description, in the weight measurement apparatus according to the conventional art, the filter coefficients $a_i$ can be changed by using the parameter x specifying a band position of an attenuation band which is physical and thus easy to grasp. Accordingly, it is possible to easily change a band position of the attenuation band. Therefore, a frequency of a noise in the weighing signal Ds, which is liable to be changed, can be filtered out easily and appropriately.

Additionally, the number of the values $\phi_k$ (k = 0, 1, ..., K) to be substituted for the parameter $\phi$ used in obtaining the coefficients $g_{i,j}$ is preferably three or more ($K \geqq 3$) for the following reasons.

According to the conventional art, an attenuation band with a width extending along an axis of frequency is moved by using the parameter x. As such, it is desired to bring a width of the attenuation band close to an appropriate band width (the band width w in the equation (4)) not only in opposite ends of a frequency range within which the band position of the attenuation band can be specified by the parameter x (which will hereinafter be referred to as a "specified frequency range"), but also in a middle portion of the specified frequency range.

To this end, the number of the values $\phi_k$ is set to three or more. This results in the sequences $\{a_{i,k}'\}$ of the reference filter coefficients being calculated based on not only reference amplitude characteristics in the opposite ends of the specified frequency range, i.e., reference amplitude characteristics exhibited when $\phi = \phi_0$ and $\phi = \phi_k$, but also reference characteristics in the middle portion thereof. The sequences $\{a_{i,k}'\}$ of the reference filter coefficients which have been calculated in that way is used in determining values of the coefficients $g_{i,j}$ in the equation (2). In other words, to set the number of the values $\phi_k$ to three or more would allow the equation (2) for the filter coefficients to be derived from not only the reference amplitude characteristics in the opposite ends of the specified frequency range, but also the reference amplitude characteristics in the middle portion thereof. This prevents a considerable difference between the appropriate band width w and the band width of the attenuation band in the middle portion of the specified frequency range, as well as between the appropriate band width w and the band width of the attenuation band in the opposite ends of the specified frequency range.

Moreover, though the above description in the conventional art has been made with respect to a weight measurement apparatus, the present invention can also be applied to a general method of designing a digital filter. Below, a brief description about a method of designing a digital filter in which a position of an attenuation band is variable will be made.

First, a plurality of sequences $\{a_{i,k}'\}$ of reference filter coefficients are calculated from reference amplitude characteristics in the same manner as described above. Subsequently, values of the coefficients $g_{i,j}$ are determined using the calculated sequences $\{a_{i,k}'\}$, and the filter coefficients $a_{i,k}$ of the digital filter are approximated by the equation (2). Then, a value is substituted for the parameter x in the equation (2), to obtain one sequence $\{a_i\}$ of the filter coefficients of the digital filter.

In order to change the band position of the attenuation band in filtering characteristics, the value of the parameter x is changed to thereby change the filter coefficients. As a result, the attenuation band is moved to a new band position newly specified by the parameter x.

By employing the foregoing method of designing a digital filter, it is possible to easily move an attenuation band. Accordingly, even if a noise frequency is liable to be changed, it is possible to eliminate a noise easily and appropriately.

Further, as the filter coefficients are obtained by an arithmetic expression, there is no need for forming the digital filter with multistage filters which are required in JP 6-21814. Therefore, a scale of a circuit of the digital filter can be reduced.

<Problems in Conventional art of the Present Invention>

In the conventional art described above, only one attenuation band is variable in a stopband, as shown in the equation (5). Yet there may be cases where a big noise is caused by a plurality of causes, and the causes vary. Accordingly, the design of a filter will be described below in which a plurality of attenuation bands can be variably set using the conventional art method.

In this case, reference amplitude characteristics are expressed by the following equation (21) in a corresponding relationship to the equation (4):

$$M(e^{j\omega},\psi)=\begin{cases}1 & 0\leqq|\omega|\leqq\omega_p\\ 0 & \omega_s\leqq|\omega|\leqq\psi_1\\ 0 & \psi_1\leqq|\omega|\leqq\psi_1+w\\ 0 & \psi_1+w\leqq|\omega|\leqq\psi_2\\ 0 & \psi_2\leqq|\omega|\leqq\psi_2+w\\ 0 & \psi_2+w\leqq|\omega|\leqq\pi\end{cases}\quad\cdots(21)$$

Also, a weight function is expressed by the following equation (22) in a corresponding relationship to the equation (5):

$$W(e^{j\omega},\psi)=\begin{cases}1 & 0\leqq|\omega|\leqq\omega_p\\ 1 & \omega_s\leqq|\omega|\leqq\psi_1\\ 10 & \psi_1\leqq|\omega|\leqq\psi_1+w\\ 1 & \psi_1+w\leqq|\omega|\leqq\psi_2\\ 10 & \psi_2\leqq|\omega|\leqq\psi_2+w\\ 1 & \psi_2+w\leqq|\omega|\leqq\pi\end{cases}\quad\cdots(22)$$

In the equations (21) and (22), " $\phi_1$" and "$\phi_2$" represent spectrum parameters controlling band positions of the respective attenuation bands, and are given as the lowest limit values of normalized angular frequencies of the respective attenuation bands.

Given that the filter coefficients in $\phi_1$ and $\phi_2$ are filter coefficients $a_{i,\ j,\ k}$, the following equation (23) is established:

$$a_{i,j,k}=\sum_{j=0}^{M}\sum_{k=0}^{L}g_{i,j,k}\psi_1^j\psi_2^k\quad\cdots(23)$$

Thus, a transfer function of the filter in which a plurality of bands are variable is expressed by the following equation (24):

$$G(\omega, \phi_1, \phi_2) = \sum_{i=0}^{N} \sum_{j=0}^{M} \sum_{k=0}^{L} g_{i,j,k} \phi_1^j \phi_2^k \cos i\omega \quad \cdots (24)$$

In the conventional art, frequency parameters of a plurality of attenuation bands themselves are used in the course of design. Accordingly, when $\phi_1 = 0.3$, $\phi_2 = 0.8$, $j = 4$, and $k = 4$, then $\phi_1^4 = 0.3^4 = 0.0081$, and $\phi_2^4 = 0.8^4 = 0.4096$ in the equation (24). As such, $\phi_1^4$ takes on a very small value compared to $\phi_2^4$, so $\phi_1$ and $\phi_2$ cannot be approximated equally in designing the filter. As a result, desired attenuation cannot be obtained in the $\phi_1$ side band.

Therefore, the preferred embodiment according to the present invention is intended for the design of a filter in which desired attenuation can be obtained in each of a plurality of attenuation bands by approximating $\phi_1$ and $\phi_2$ equally in the course of design.

<Description of Preferred Embodiment of the Present Invention>

As shown in Fig. 15, desired frequency characteristics in which K stopbands (attenuation bands) are variable are expressed by the following equation (25):

$$D(\omega, \phi_1, \phi_2, \cdots, \phi_K, \delta_1, \delta_2, \cdots, \delta_K) = \begin{cases} 1 & 0 \leqq \omega \leqq \omega_p \\ 0 & \omega_s \leqq |\omega| \leqq \phi_1 + \delta_1 - \tau_1/2 \\ 0 & \phi_1 + \delta_1 - \tau_1/2 < \omega \leqq \phi_1 + \delta_1 + \tau_1/2 \\ 0 & \phi_1 + \delta_1 + \tau_1/2 < \omega \leqq \phi_2 + \delta_2 - \tau_2/2 \\ 0 & \phi_2 + \delta_2 - \tau_2/2 < \omega \leqq \phi_2 + \delta_2 + \tau_2/2 \\ & \vdots \\ 0 & \phi_K + \delta_K - \tau_K/2 < \omega \leqq \phi_K + \delta_K + T_K/2 \\ 0 & \phi_K + \delta_K + \tau_K/2 < \omega \leqq \pi \end{cases} \quad \cdots (25)$$

In the equation (25), "$\omega_p$" represents a normalized angular frequency of an edge of a passband, "$\omega_s$" represents a normalized angular frequency of an edge of a stopband, "$\phi_1, \phi_2, \ldots \phi_K$" represent a center normalized angular frequency of each band where great stopband attenuation is required, and "$\tau_1, \tau_2, \ldots \tau_K$" represent a band width of each band where great stopband attenuation is required. Also, "$\delta_1, \delta_2, \ldots \delta_K$" represent a spectrum parameter, and is expressed by the following equation (26):

$$\begin{aligned} &\delta_1 \in [\delta_{1min}, \delta_{1max}] \\ &\delta_2 \in [\delta_{2min}, \delta_{2max}] \\ &\vdots \\ &\delta_K \in [\delta_{Kmin}, \delta_{Kmax}] \end{aligned} \quad \cdots (26)$$

Additionally, a weight function is expressed by the following equation (27):

$$W(\omega, \phi_1, \phi_2, \cdots, \phi_K, \delta_1, \delta_2, \cdots, \delta_K) = \begin{cases} 1 & 0 \leqq \omega \leqq \omega_p \\ 1 & \omega_s \leqq \omega \leqq \phi_1 + \delta_1 - \tau_1/2 \\ g_1 & \phi_1 + \delta_1 - \tau_1/2 < \omega \leqq \phi_1 + \delta_1 + \tau_1/2 \\ 1 & \phi_1 + \delta_1 + \tau_1/2 < \omega \leqq \phi_2 + \delta_2 - \tau_2/2 \\ g_2 & \phi_2 + \delta_2 - \tau_2/2 < \omega \leqq \phi_2 + \delta_2 + \tau_2/2 \\ & \vdots \\ g_K & \phi_K + \delta_K - \tau_K/2 < \omega \leqq \phi_K + \delta_K + \tau_K/2 \\ 1 & \phi_K + \delta_K + \tau_K/2 < \omega \leqq \pi \end{cases} \quad \cdots (27)$$

In the equation (27), "$g_1, g_2, ...g_K$" represent a weight of each band where great stopband attenuation is required, and takes on a positive real number value. As described above, the preferred embodiment according to the present invention is characterized in that each band is specified by a spectrum parameter not as the lowest limit value of a frequency as in the above-described conventional art, but as the amount of deviation from its center frequency (the amount of displacement from a center frequency in a range where each attenuation band should vary). Other than providing a spectrum parameter as the amount of deviation from a center frequency, the preferred embodiment is the same as the above-described conventional art. Detailed descriptions of the apparatus configuration and the like are thus omitted.

A frequency response of a transfer function of a 2Nth order linear phase FIR filter in which a plurality of stopbands are variable approximating characteristics having the above-mentioned desired characteristics and weight is expressed by the following equation (28) using the spectrum parameter:

$$H(\omega, \phi_1, \phi_2, \cdots, \phi_K, \delta_1, \delta_2, \cdots, \delta_K) = \sum_{i=0}^{N} h(i, \delta_1, \delta_2, \cdots, \delta_K) \cos(i\omega) \quad \cdots (28)$$

In the equation (28), a value of h $(i, \delta_1, \delta_2, ... \delta_K)$ changes as the spectrum parameter changes. Thus by extending the above-described conventional art, coefficients are approximated using an $L_i$-th order polynomial for each spectrum parameter.

$$h(i, \delta_1, \delta_2, \cdots, \delta_K) = \sum_{l_1=0}^{L_1} \sum_{l_2=0}^{L_2} \cdots \sum_{l_K=0}^{L_K} g(i, l_1, l_2, \cdots, l_K)\, \delta_1^{l_1} \delta_2^{l_2} \cdots \delta_K^{l_K} \quad \cdots (29)$$

When $\phi_1 = 0.3$, $\phi_2 = 0.8$, $\delta_1 = 0.2$, $\delta_2 = 0.2$, $1_1 = 4$, and $1_2 = 4$ in the equation (29) where $\delta_1$ and $\delta_2$ are provided instead of $\phi_1$ and $\phi_2$ as parameters, $\delta_1^4$ and $\delta_2^4$ take on the same value of 0.0016. Accordingly, $\delta_1$ and $\delta_2$ can be approximated equally in designing the filter, which in turn allows the design of a desired filter.

For brevity, an example where K = 2 will now be described.

An evaluation function where amplitude characteristics $|H(\omega, \phi_1, \phi_2, \delta_1, \delta_2)|$ of a transfer function by substituting the equation (29) into the equation (28) becomes optimum in terms of weighed least square between the reference amplitude characteristics in the equation (25) and the weight function in the equation (27) is provided by the following equation (30):

$$J=\int_{\delta_{1min}}^{\delta_{1max}}\int_{\delta_{2min}}^{\delta_{2max}}\int_0^{\pi} W(\omega,\phi_1,\phi_2,\delta_1,\delta_2)\{D(\omega,\phi_1,\phi_2,\delta_1,\delta_2)-H(\omega,\phi_1,\phi_2,\delta_1,\delta_2)\}^2 d\omega d\delta_1 d\delta_2$$
$$=\int_{\delta_{1min}}^{\delta_{1max}}\int_{\delta_{2min}}^{\delta_{2max}}\int_0^{\pi} W(\omega,\phi_1,\phi_2,\delta_1,\delta_2)\{D(\omega,\phi_1,\phi_2,\delta_1,\delta_2)-\sum_{i=0}^{N}\sum_{l_1=0}^{L_1}\sum_{l_2=0}^{L_2} g(i,l_1,l_2)\delta_{1,m1}^{l_1}\delta_{2,m2}^{l_2}\cos(i\omega_f)\}^2 d\omega d\delta_1 d\delta_2 \quad \cdots(30)$$

In the equation (30), optimum coefficients g (i, $1_1$, $1_2$) are calculated such that the evaluation function in the equation (30) becomes minimum. When the amount of variation in each spectrum parameter is divided into $M_\delta$+1 equal parts, and a frequency area from 0 to π is divided into $M_f$+1 equal parts in the evaluation function in the equation (30), discrete evaluation functions are obtained as expressed by the following equation (31):

$$J_D=\sum_{m1=0}^{M_\delta}\sum_{m2=0}^{M_\delta}\sum_{f=0}^{M_f} W(\omega_f,\phi_1,\phi_2,\delta_{1,m1},\delta_{2,m2})\{D(\omega_f,\phi_1,\phi_2,\delta_{1,m1},\delta_{2,m2})-\sum_{i=0}^{N}\sum_{l_1=0}^{L_1}\sum_{l_2=0}^{L_2} g(i,l_1,l_2)\delta_{1,m1}^{l_1}\delta_{2,m2}^{l_2}\cos(i\omega_f)\}^2 \quad \cdots(31)$$

In order to minimize the discrete evaluation functions in the equation (31), coefficients g (p, q, r) are partially differentiated and assumed to be zero. The result is expressed by the following equation (32):

$$\frac{\partial J_D}{\partial_g(i,l_1,l_2)}=\sum_{m1=0}^{M_\delta}\sum_{m2=0}^{M_\delta}\sum_{f=0}^{M_f}[2W(\omega_f,\phi,\delta)\{D(\omega_f,\phi,\delta)-\sum_{i=0}^{N}\sum_{l_1=0}^{L_1}\sum_{l_2=0}^{L_2} g(i,l_1,l_2)C(i,l_1,l_2,f)\}C(p,q,r,f)]=0 \quad \cdots(32)$$

Note that the following equation (33) applies:

$$\phi=(\phi_1,\phi_2)$$
$$\delta=(\delta_{1,m1},\delta_{2,m2})$$
$$C(i,s,t,f)=\delta_{1,m1}^{s}\delta_{2,m2}^{t}\cos(i\omega_f) \quad \cdots(33)$$

The equations (32) and (33) are arranged as follows:

$$\sum_{m1=0}^{M\delta}\sum_{m2=0}^{M\delta}\sum_{f=0}^{Mf} W(\omega_f,\phi,\delta)D(\omega_f,\phi,\delta)C(p,q,r,f)=$$

$$\sum_{i=0}^{N}\sum_{l1=0}^{L1}\sum_{l2=0}^{L2} g(i,l_1,l_2)\cdot$$

$$\sum_{m1=0}^{M\delta}\sum_{m2=0}^{M\delta}\sum_{f=0}^{Mf} W(\omega_f,\phi,\delta)C(i,l_1,l_2,f)C(p,q,r,f) \quad \cdots(34)$$

Then, p = 0, 1, ...N, q = 0, 1, ... $L_1$, and r = 0, 1, ...,$L_2$ are substituted into the equation (34), and a multi-dimensional array for the spectrum parameters is transformed to a first-dimensional array. The result array is expressed by the following equation (35):

$$AWA^tG=AWD \quad \cdots(35)$$

Note that the following equations (36) to (39) apply:

$$G=[g(0,0,0),g(0,0,1),\cdots,g(0,0,L_2),g(0,1,0),\cdots,g(0,1,L_2),\cdots,g(N,L_1,L_2)]^T \quad \cdots(36)$$

$$W=diag\begin{bmatrix}W(\omega_0,\phi_1,\phi_2,\delta_{1.0},\delta_{2.0})\\ \vdots \\ W(\omega_{Mf},\phi_1,\phi_2,\delta_{1.0},\delta_{2.0})\\ W(\omega_0,\phi_1,\phi_2,\delta_{1.1},\delta_{2.0})\\ \vdots \\ W(\omega_{Mf},\phi_1,\phi_2,\delta_{1.1},\delta_{2.0})\\ \vdots \\ W(\omega_{Mf},\phi_1,\phi_2,\delta_{1.M\delta},\delta_{2.M\delta})\end{bmatrix}^T \quad \cdots(37)$$

$$D=\begin{bmatrix} D(\omega_0, \phi_1, \phi_2, \delta_{1,0}, \delta_{2,0}) \\ \vdots \\ D(\omega_{Mf}, \phi_1, \phi_2, \delta_{1,0}, \delta_{2,0}) \\ D(\omega_0, \phi_1, \phi_2, \delta_{1,1}, \delta_{2,0}) \\ \vdots \\ D(\omega_{Mf}, \phi_1, \phi_2, \delta_{1,1}, \delta_{2,0}) \\ \vdots \\ D(\omega_{Mf}, \phi_1, \phi_2, \delta_{1,M\delta}, \delta_{2,M\delta}) \end{bmatrix} \cdots (38)$$

$$A=\begin{bmatrix} a(0,0) & a(0,1) & \cdots & a(0,v) \\ a(1,0) & a(1,1) & & \vdots \\ \vdots & & \ddots & \vdots \\ a(u,0) & a(u,1) & \cdots & a(u,v) \end{bmatrix} \cdots (39)$$

In the above equations (36) to (39), "u" = ($M_f$ +1) ($M_\delta$ +1) ($M_\delta$ + 1), and "v" = (N+1) ($L_1$+1) ($L_2$+1). The "diag [·]" represents a diagonal matrix including elements in [·]. An i, j-th element a (i, j) in a matrix A is expressed by the following equation (40):

$$a(i, j)=\delta_{1,m1}^{l1}\delta_{2,m2}^{l2}\cos(k\omega_f) \qquad \cdots (40)$$

Note that the following equation (41) applies:

$$f=\left\lfloor \frac{i}{(M_\delta+1)(M_\delta+1)} \right\rfloor \qquad \cdots (41)$$
$$k=\mathrm{mod}(j, (L_1+1)(L_2+1))$$

The "j" changes consecutively from 0 to (N+1) ($L_1$+1) ($L_2$+1) as indicated below, with its corresponding $l_{1,j}$, $l_{2,j}$ changing as indicated below:

$$u = [0, 1, \cdots, L_1+1, L_1+2, \cdots, j, \cdots, L_1+L_2+2, \cdots, \cdots, (N+1)(L_1+1)(L_2+1)]$$

$$\Updownarrow$$

$$l_1 = [\underbrace{\underbrace{0, \cdots, 0}_{L_2+1}, \underbrace{1, \cdots, l_{1,j}, \cdots, 1}_{L_2+1}, \cdots, L_1, \cdots, L_1}_{(L_1+1)(L_2+1)} \quad N, \cdots, N] \qquad \cdots (42)$$

$$l_2 = [\underbrace{\underbrace{0, \cdots, L_2}_{L_2+1}, \underbrace{0, \cdots, l_{2,j}, \cdots, L_2}_{L_2+1}, \cdots, 0, \cdots, L_2}_{(L_1+1)(L_2+1)} \quad 0, \cdots, L_2+1] \qquad \cdots (43)$$

Note that

$$\lfloor c \rfloor$$

represents a maximum integral value that does not exceed "c", and mod (a, b) represents the remainder obtained when "a" is divided by "b".

In view of the foregoing, optimum coefficients are expressed by the following equation (44):

$$G = (AWA^T)^{-1} AWD \qquad \cdots (44)$$

Next, as a specific design example, specifications in which two stopbands each having large attenuation are variable are provided as the following table 1:

| | |
|---|---|
| [SPECIFICATIONS] | |
| FILTER ORDER : 60 | EACH POLYNOMIAL ORDER : $L_1=L_2=6$ |
| PASSBAND : 0-0.1π | STOPBAND : 0.2π-π |
| WEIGHT : 1 | WEIGHT : 1 |
| STOPBAND HAVING LARGE ATTENUATION | |
| CENTER ANGULAR FREQUENCY : $\phi_1=0.35\pi$, $\phi_2=0.75\pi$ | |

(continued)

| |
|---|
| [SPECIFICATIONS]<br>BAND WIDTH: $\tau_1=\tau_2=0.1$<br>AMOUNT OF VARIATION IN ANGULAR FREQUENCY: $\delta_1=\delta_2=-0.05\sim0.05$<br>WEIGHT OF EACH BAND : 10 |

A passband is separated into 20 equal parts and the entire stopband is separated into 500 equal parts in this example. Also, the amounts of variation in angular frequency of great attenuation are separated at 0.05 intervals respectively. The result amplitude characteristics are shown in Figs. 17 through 26. These figures show that the amplitude characteristics vary as the spectrum parameters $\delta_1$ and $\delta_2$ vary, respectively, to be approximated to desired amplitude characteristics. Further, respective maximum errors when the spectrum parameters vary are shown in the following table 2:

| $\delta_1$ | $\delta_2$ | MAXIMUM ERROR OF SMALL ATTENUATION | MAXIMUM ERROR OF GREAT ATTENUATION |
|---|---|---|---|
| -0.05 | -0.05 | 0.0028(-51dB) | 0.000028(-91dB) |
| -0.05 | 0 | 0.0028(-51dB) | 0.000028(-91dB) |
| -0.05 | 0.05 | 0.0028(-51dB) | 0.000029(-90dB) |
| 0 | -0.05 | 0.0028(-51dB) | 0.000052(-86dB) |
| 0 | 0 | 0.0031(-50dB) | 0.000052(-86dB) |
| 0 | 0.05 | 0.0031(-50dB) | 0.000052(-86dB) |
| 0.05 | -0.05 | 0.0032(-50dB) | 0.000013(-86dB) |
| 0.05 | 0 | 0.0034(-49dB) | 0.000013(-98dB) |
| 0.05 | 0.05 | 0.0034(-49dB) | 0.000014(-97dB) |

The amplitude characteristics for an unseparated point of $\delta_1 = 0.0$ and $\delta_2 = 0.01$ are also shown in Fig. 26. Fig. 26 shows that good amplitude characteristics with an error of 0.0034 (-49dB) in an area of small attenuation and an error of 0.000013 (-97dB) in an area of great attenuation are obtained even for an unseparated point. It is understood from the above that the filter according to the present embodiment can successively move a plurality of stopbands.

For comparison purposes, an FIR filter was designed that has fixed coefficients with an unmoved stopband where the amount of great stopband attenuation is not less than at least -90dB, assuming that from 0.2 $\pi$ to 0.3 $\pi$ is a weight "1", and from 0.3 $\pi$ to 0.9 $\pi$ is a weight "10". The result amplitude characteristics are shown in Fig. 16. This filter is of an 80th order which requires more orders than a 60th order filter in which a stopband is variable, so the amount of delay thereof is greater than that of a filter in which a stopband is variable. Therefore, designing a filter in which a plurality of stopbands are locally variable like the filter according to the present embodiment is effective in reducing a filter order as in the conventional art, and is effective for high-speed and high-accuracy measurement.

While the design of a filter in which a plurality of stopbands are variable has been discussed above, the present invention is also applicable to the design of a filter in which one stopband is variable. Further, while the design of a low pass filter has been discussed above, the present invention is also applicable to the design of other filters than a low pass filter (such as a band path filter and a high pass filter). Still further, while the design of an FIR filter has been described, the present invention is also applicable to the design of an IIR filter.

While the invention has been shown and described in detail, the foregoing description is in all aspects illustrative and not restrictive. It is therefore understood that numerous modifications and variations can be devised without departing from the scope of the invention.

## Claims

1. A noise eliminating apparatus comprising:

a signal processor <5> for carrying out a filtering process on a digital signal by using variable filter coefficients <h>; and

a filter coefficient calculator <6> for calculating said filter coefficients using a predetermined arithmetic expression and outputting said filter coefficients to said signal processor, wherein

said arithmetic expression includes parameters < δ > specifying respective band positions of a plurality of attenuation bands where attenuation is to be enhanced locally in a stopband of amplitude characteristics of said filtering process, and
said filter coefficient calculator substitutes input values of said parameters into said arithmetic expression, to change said filter coefficients so that said plurality of attenuation bands are independently movable to respective desired band positions specified by said parameters.

**2.** The noise eliminating apparatus according to claim 1, wherein
each of said parameters is given as the amount of displacement from a center frequency in a range where a corresponding attenuation band among said plurality of attenuation bands is to vary.

**3.** The noise eliminating apparatus according to claim 1 or 2, further comprising
a data entry part <7> for receiving said values of said parameters which are input externally to said noise eliminating apparatus and outputting said values of said parameters to said filter coefficient calculator.

**4.** The noise eliminating apparatus according to claim 1 or 2, wherein
said signal processor carries out said filtering process by using a finite impulse response (FIR) digital filter.

**5.** A weight measurement apparatus comprising:

a measurer <1, 2, 3, 4> for detecting a weight of an object; and
a noise eliminating apparatus for carrying out a filtering process on a digital signal which is obtained as a measurement result by said measurer,
said noise eliminating apparatus including
a signal processor <5> for carrying out said filtering process on said digital signal by using variable filter coefficients <h>, and
a filter coefficient calculator <6> for calculating said filter coefficients using a predetermined arithmetic expression and outputting said filter coefficients to said signal processor, wherein
said arithmetic expression includes parameters < δ > specifying respective band positions of a plurality of attenuation bands where attenuation is to be enhanced locally in a stopband of amplitude characteristics of said filtering process, and
said filter coefficient calculator substitutes input values of said parameters into said arithmetic expression, to change said filter coefficients so that said plurality of attenuation bands are independently movable to respective desired band positions specified by said parameters.

**6.** A method of eliminating a noise, comprising the steps of:

(a) calculating filter coefficients <h> using a predetermined arithmetic expression; and
(b) carrying out a filtering process on a digital signal by using said filter coefficients calculated in said step (a), wherein
said arithmetic expression includes parameters < δ > specifying respective band positions of a plurality of attenuation bands where attenuation is to be enhanced locally in a stopband of amplitude characteristics of said filtering process,
said step (a) includes the step of (a-1) substituting values of said parameters into said arithmetic expression, to change said filter coefficients, and
said plurality of attenuation bands are independently moved to respective desired band positions specified by said parameters by performing said step (a-1).

**7.** The method of eliminating a noise according to claim 6, wherein
each of said parameters is given as the amount of displacement from a center frequency in a range where a corresponding attenuation band among said plurality of attenuation bands is to vary.

**8.** The method of eliminating a noise according to claim 6 or 7, further comprising the step of

(c) receiving said values of said parameters, wherein
said values of said parameters received in said step (c) are substituted into said arithmetic expression in said step (a-1).

**9.** A method of designing a digital filter in which respective band positions of a plurality of attenuation bands where attenuation is to be enhanced locally in a stopband of amplitude characteristics are variable, said method comprising the steps of:

(a) calculating a plurality of sequences of reference filter coefficients based on reference amplitude characteristics of said digital filter;
(b) approximating filter coefficients <h> of said digital filter using a predetermined arithmetic expression including parameters < δ > specifying said respective band positions of said plurality of attenuation bands, based on said plurality of sequences of said reference filter coefficients; and
(c) calculating said filter coefficients using said predetermined arithmetic expression, wherein
said step (c) includes the step of (c-1) substituting values of said parameters into said predetermined arithmetic expression, to change said filter coefficients, and
said plurality of attenuation bands are independently moved to respective desired band positions specified by said parameters by performing said step (c-1).

**10.** The method of designing a digital filter according to claim 9, wherein
each of said parameters is given as the amount of displacement from a center frequency in a range where a corresponding attenuation band among said plurality of attenuation bands is to vary.

F I G . 1

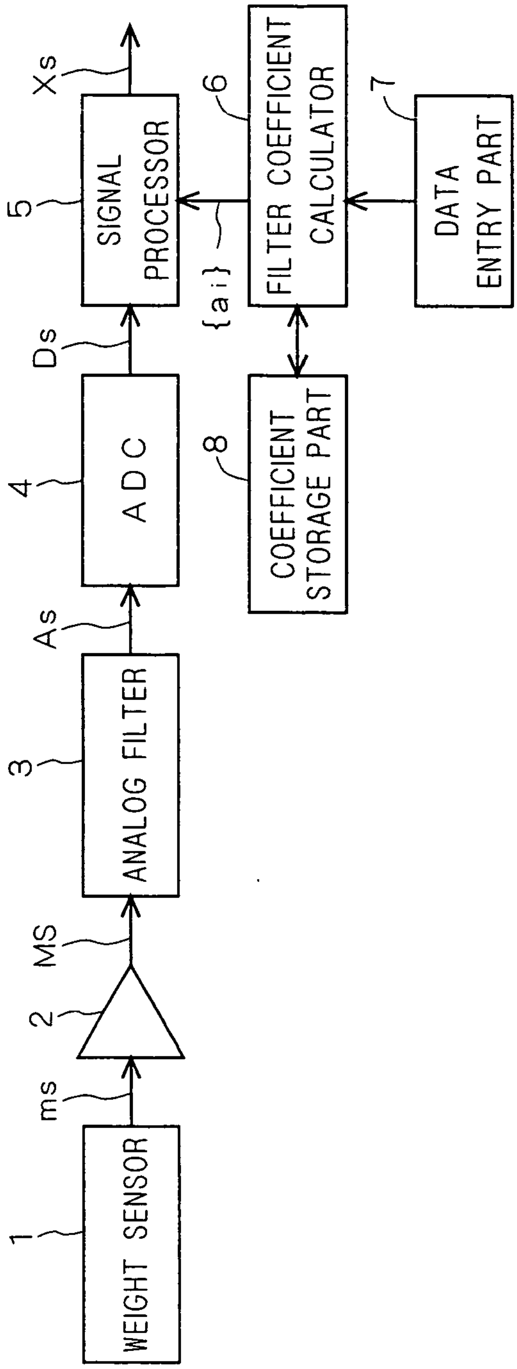
WEIGHT SENSOR
ANALOG FILTER
ADC
SIGNAL PROCESSOR
FILTER COEFFICIENT CALCULATOR
DATA ENTRY PART
COEFFICIENT STORAGE PART
ms
MS
As
Ds
Xs
{ai}
1
2
3
4
5
6
7
8

F I G . 2

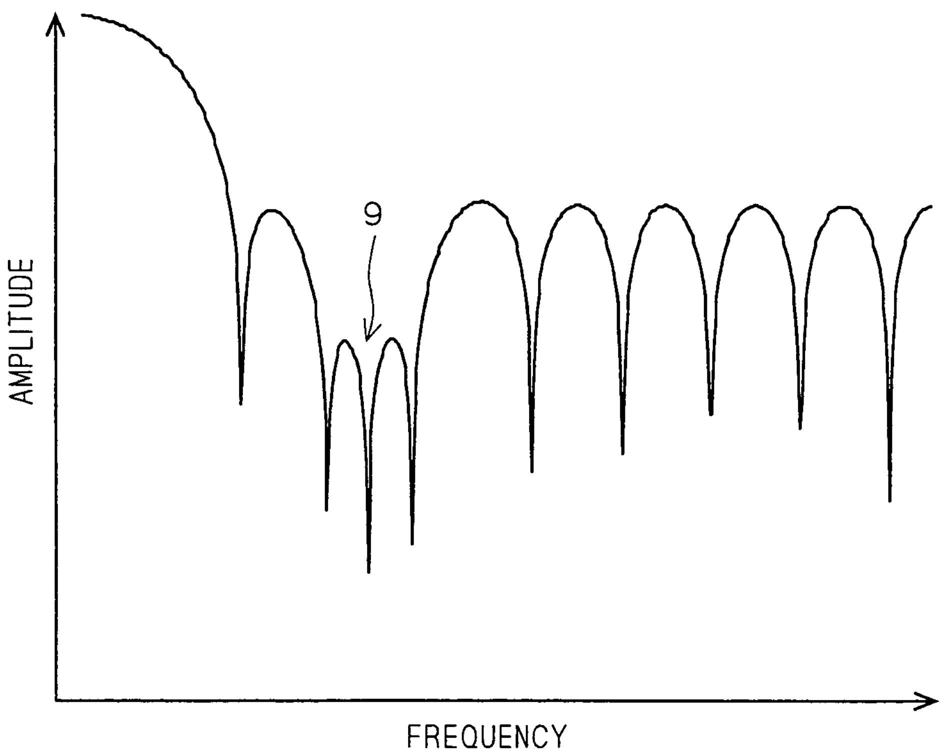

FIG. 3

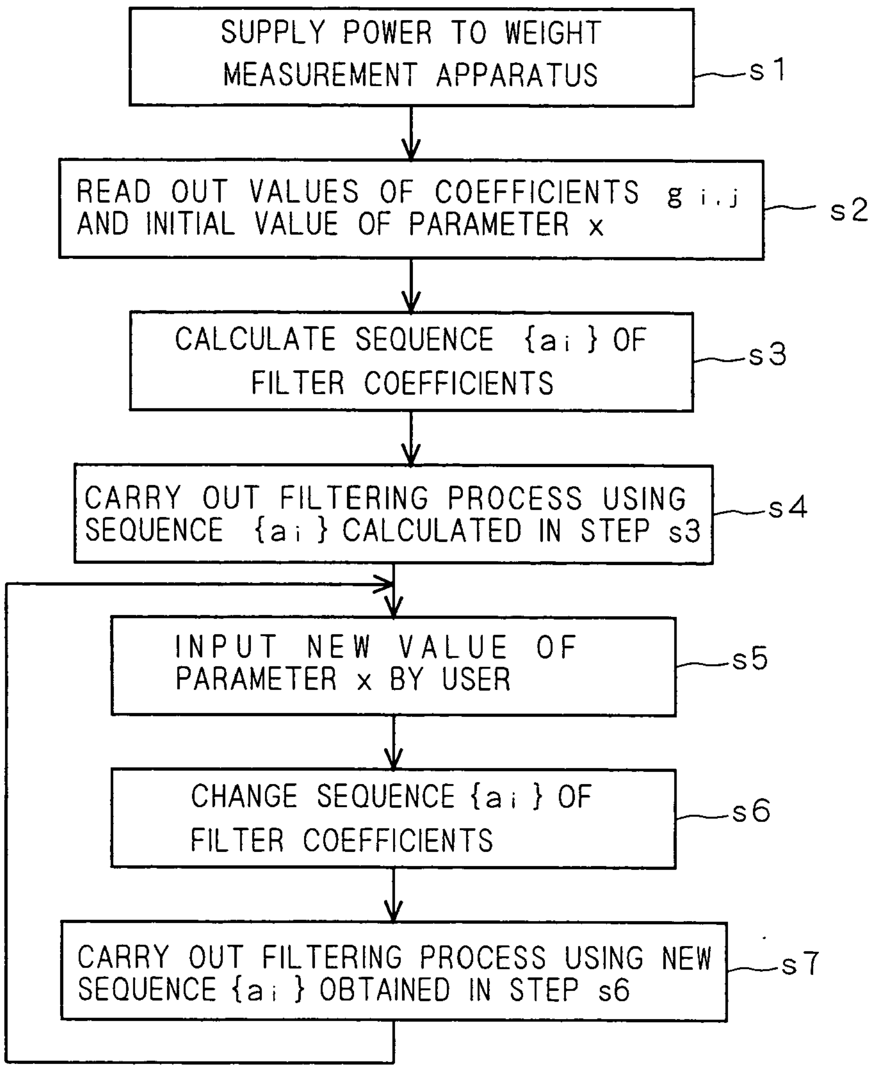
SUPPLY POWER TO WEIGHT MEASUREMENT APPARATUS
s1
READ OUT VALUES OF COEFFICIENTS g i,j AND INITIAL VALUE OF PARAMETER x
s2
CALCULATE SEQUENCE {ai} OF FILTER COEFFICIENTS
s3
CARRY OUT FILTERING PROCESS USING SEQUENCE {ai} CALCULATED IN STEP s3
s4
INPUT NEW VALUE OF PARAMETER x BY USER
s5
CHANGE SEQUENCE {ai} OF FILTER COEFFICIENTS
s6
CARRY OUT FILTERING PROCESS USING NEW SEQUENCE {ai} OBTAINED IN STEP s6
s7

F I G . 4

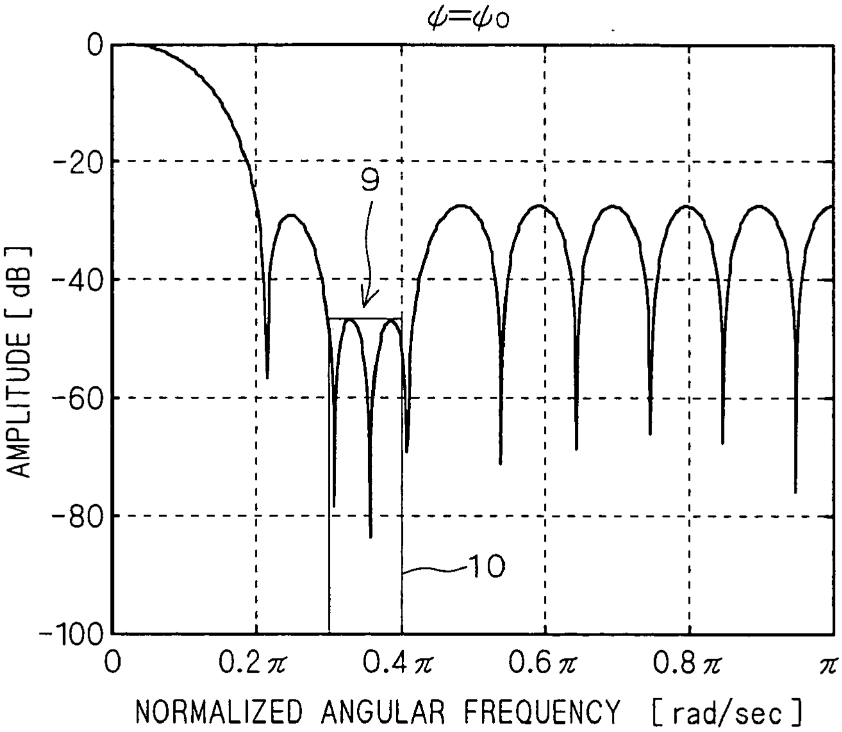
ψ=ψ0
0
-20
-40
-60
-80
-100
AMPLITUDE [ dB ]
9
10
0
0.2π
0.4π
0.6π
0.8π
π
NORMALIZED ANGULAR FREQUENCY [rad/sec]

F I G . 5

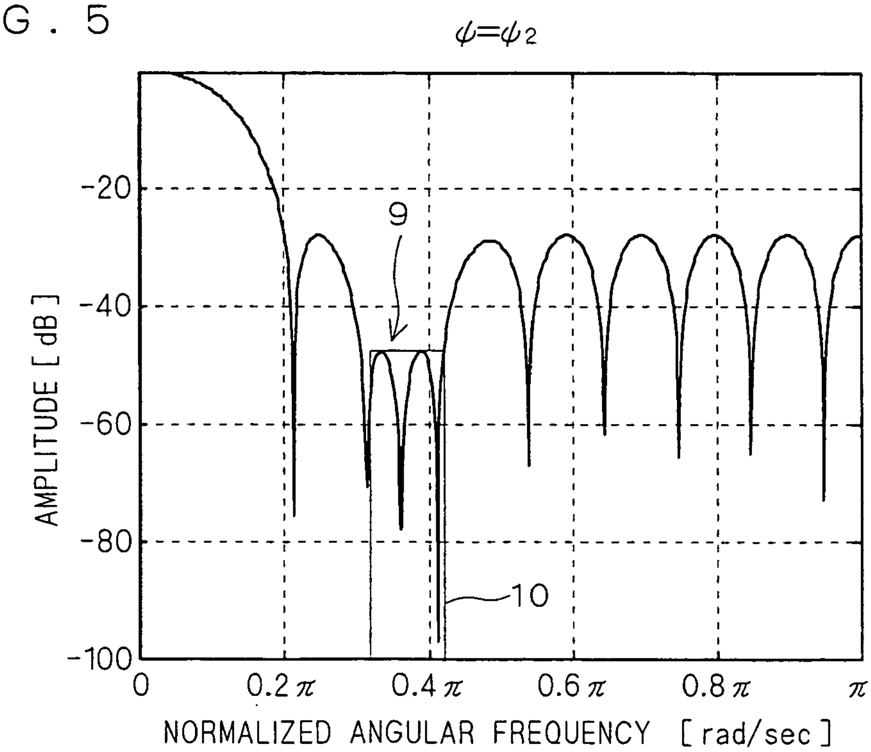
ψ=ψ2
-20
-40
-60
-80
-100
AMPLITUDE [ dB ]
9
10
0
0.2π
0.4π
0.6π
0.8π
π
NORMALIZED ANGULAR FREQUENCY [rad/sec]

FIG. 6

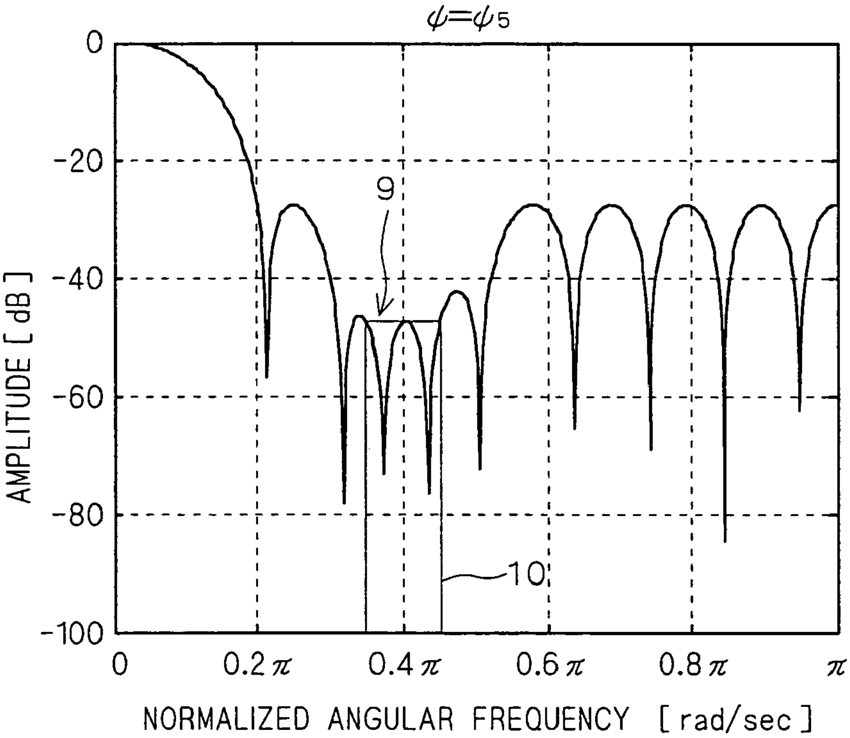
ψ=ψ5
0
-20
-40
-60
-80
-100
AMPLITUDE [ dB ]
9
10
0
0.2π
0.4π
0.6π
0.8π
π
NORMALIZED ANGULAR FREQUENCY [rad/sec]

FIG. 7

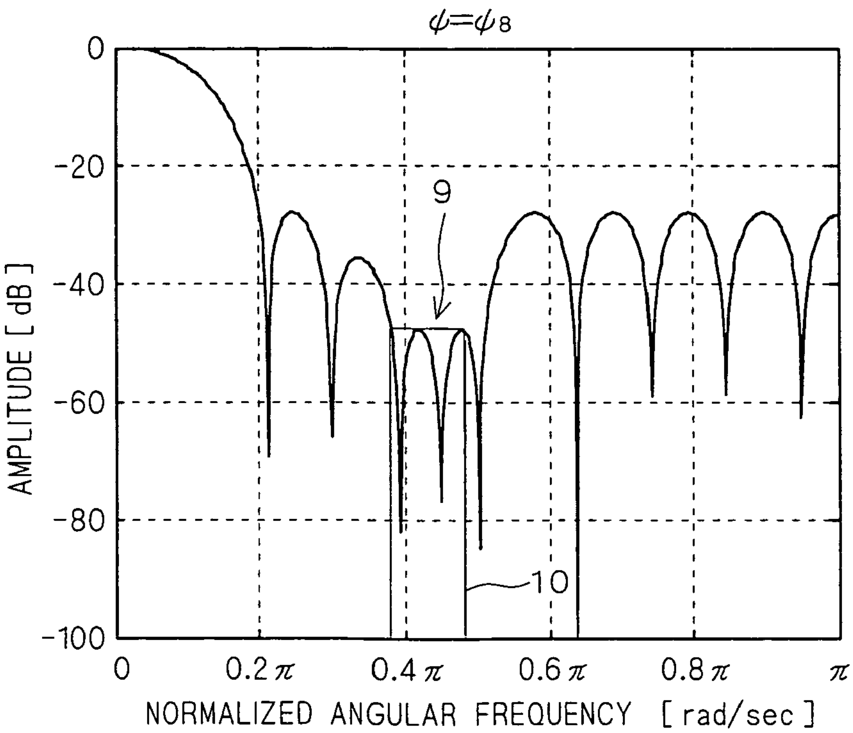
ψ=ψ8
0
-20
-40
-60
-80
-100
AMPLITUDE [ dB ]
9
10
0
0.2π
0.4π
0.6π
0.8π
π
NORMALIZED ANGULAR FREQUENCY [rad/sec]

F I G . 8

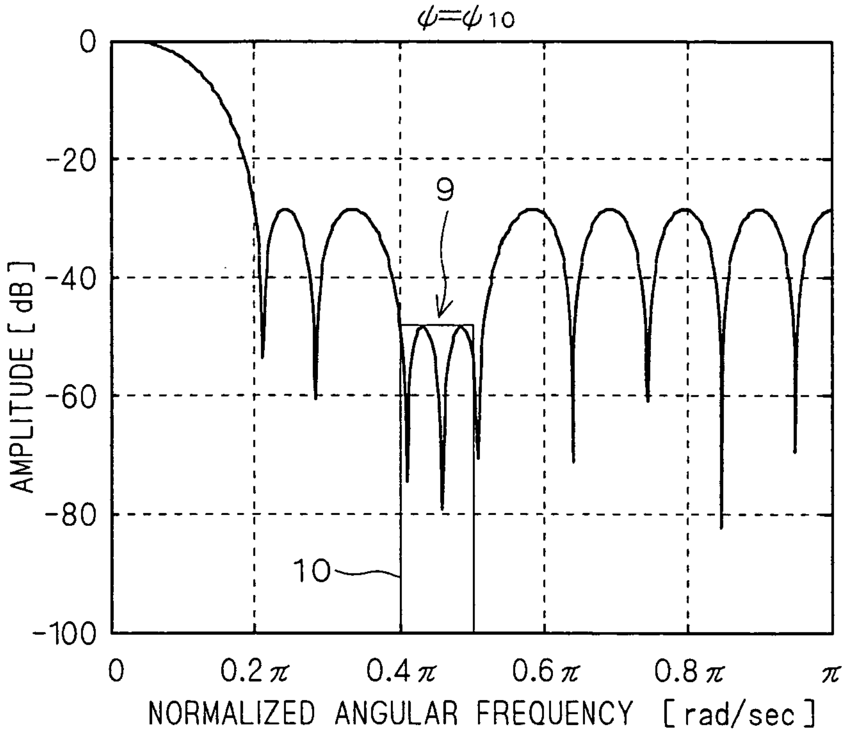


F I G . 9

| | ORDER OF POLYNOMIAL | | | | | |
|---|---|---|---|---|---|---|
| | j = 0 | j = 1 | j = 2 | j = 3 | j = 4 | j = 5 |
| i=0 | 7.2E-07 | -2.4E-05 | 0.000295 | -0.001430 | 0.001546 | 0.126876 |
| i=1 | 3.6E-07 | -1.2E-05 | 0.000152 | -0.000800 | 0.001259 | 0.243199 |
| i=2 | -8.9E-07 | 2.77E-05 | -0.000320 | 0.001367 | -0.000370 | 0.216402 |
| i=3 | 7.8E-07 | -2.1E-05 | 0.000188 | -0.000790 | 0.001842 | 0.182503 |
| i=4 | 1.79E-06 | -5.6E-05 | 0.000624 | -0.002890 | 0.003532 | 0.144324 |
| i=5 | 1E-07 | -3.6E-06 | 5.47E-05 | -0.000310 | 0.000276 | 0.099327 |
| i=6 | -1.8E-06 | 5.55E-05 | -0.000620 | 0.002845 | -0.003440 | 0.050270 |
| i=7 | -5.8E-07 | 1.86E-05 | -0.000210 | 0.001067 | -0.001900 | 0.011368 |
| i=8 | 2.5E-07 | -1.4E-05 | 0.000215 | -0.001100 | 3.88E-05 | -0.002440 |
| i=9 | -1.1E-06 | 3.83E-05 | -0.000490 | 0.002576 | -0.004780 | 0.006051 |
| i=10 | -3.9E-07 | 1.64E-05 | -0.000240 | 0.001269 | -0.001310 | -0.035490 |

F I G . 1 0

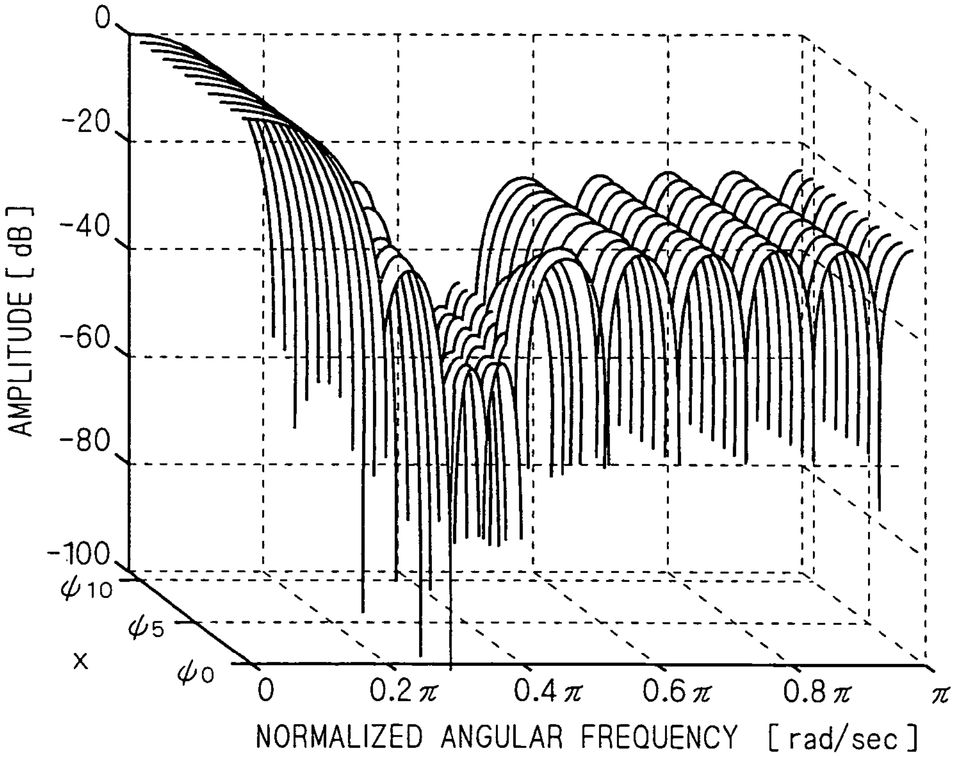
0
-20
-40
-60
-80
-100
AMPLITUDE [ dB ]
ψ10
ψ5
ψ0
x
0
0.2π
0.4π
0.6π
0.8π
π
NORMALIZED ANGULAR FREQUENCY [ rad/sec ]

F I G . 1 1

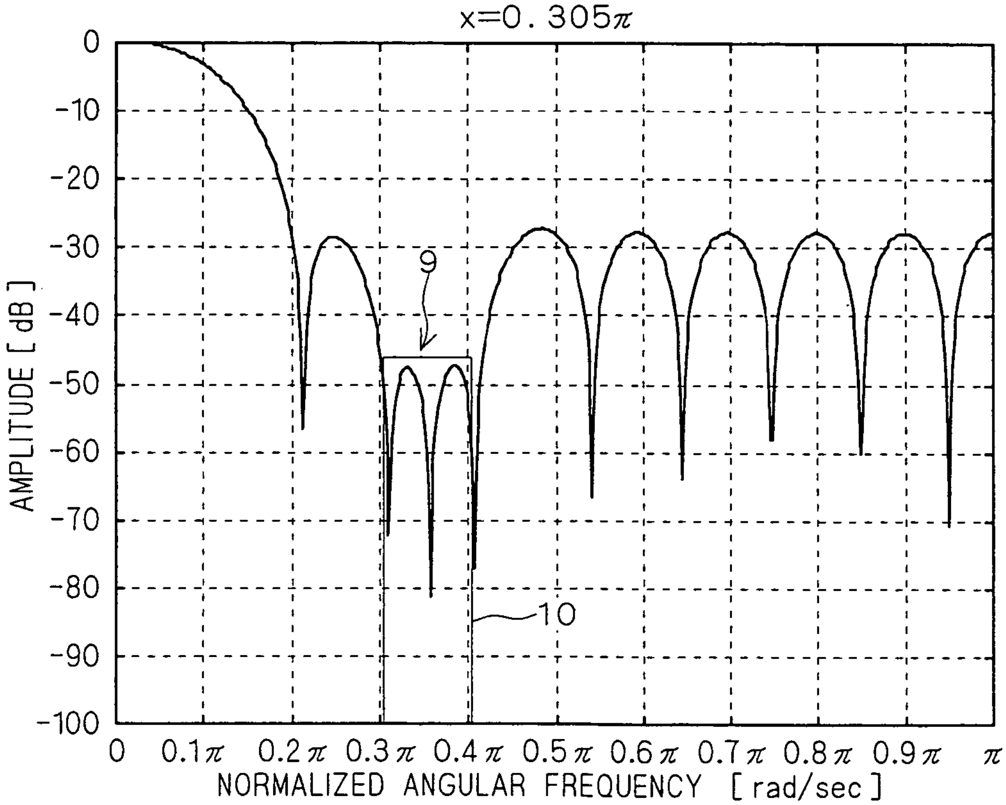
x=0. 305π
0
-10
-20
-30
-40
-50
-60
-70
-80
-90
-100
AMPLITUDE [ dB ]
9
10
0
0.1π
0.2π
0.3π
0.4π
0.5π
0.6π
0.7π
0.8π
0.9π
π
NORMALIZED ANGULAR FREQUENCY [ rad/sec ]

F I G . 1 2

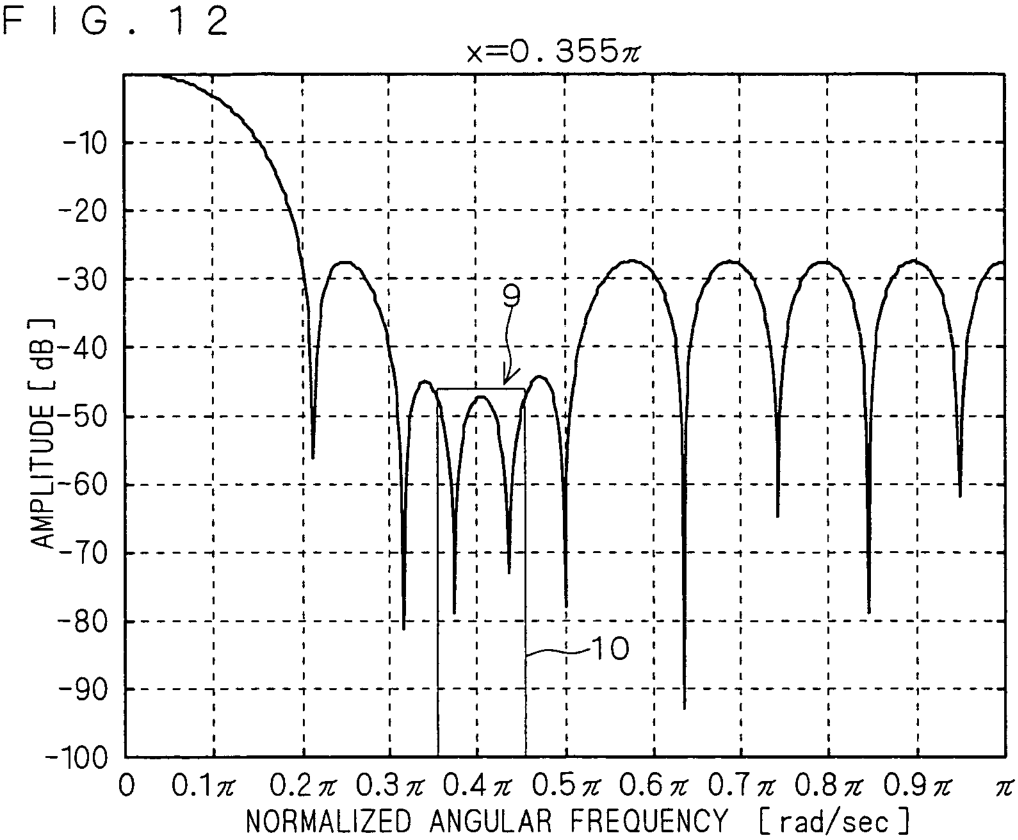
x=0.355π
-10
-20
-30
-40
-50
-60
-70
-80
-90
-100
AMPLITUDE [ dB ]
9
10
0 0.1π 0.2π 0.3π 0.4π 0.5π 0.6π 0.7π 0.8π 0.9π π
NORMALIZED ANGULAR FREQUENCY [rad/sec]

F I G . 1 3

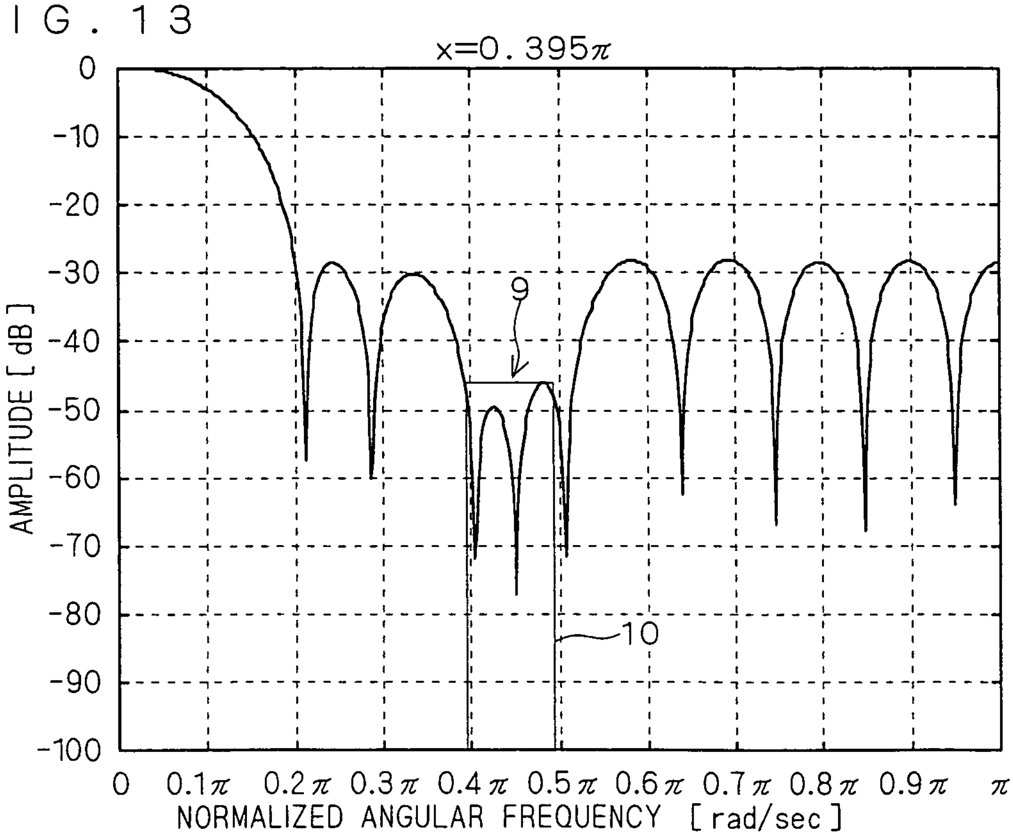
x=0.395π
0
-10
-20
-30
-40
-50
-60
-70
-80
-90
-100
AMPLITUDE [ dB ]
9
10
0 0.1π 0.2π 0.3π 0.4π 0.5π 0.6π 0.7π 0.8π 0.9π π
NORMALIZED ANGULAR FREQUENCY [rad/sec]

F I G . 1 4

| | MAXIMUM ERROR IN OPTIMUM FILTER | | | | MAXIMUM ERROR IN APPROXIMATION BY Mth ORDER POLYNOMIAL | | | |
|---|---|---|---|---|---|---|---|---|
| | FREQUENCY RANGE AR1 | FREQUENCY RANGE AR2 | FREQUENCY RANGE AR3 | FREQUENCY RANGE AR4 | FREQUENCY RANGE AR1 | FREQUENCY RANGE AR2 | FREQUENCY RANGE AR3 | FREQUENCY RANGE AR4 |
| $\psi_0$ | 0.0420 | 0.0420 | 0.0042 | 0.0420 | 0.0424 | 0.0383 | 0.0043 | 0.0425 |
| $\psi_1$ | 0.0420 | 0.0420 | 0.0042 | 0.0420 | 0.0406 | 0.0398 | 0.0043 | 0.0425 |
| $\psi_2$ | 0.0420 | 0.0420 | 0.0042 | 0.0420 | 0.0407 | 0.0413 | 0.0042 | 0.0408 |
| $\psi_3$ | 0.0420 | 0.0420 | 0.0042 | 0.0420 | 0.0415 | 0.0417 | 0.0042 | 0.0416 |
| $\psi_4$ | 0.0420 | 0.0420 | 0.0042 | 0.0420 | 0.0423 | 0.0420 | 0.0043 | 0.0423 |
| $\psi_5$ | 0.0420 | 0.0420 | 0.0042 | 0.0420 | 0.0427 | 0.0424 | 0.0044 | 0.0428 |
| $\psi_6$ | 0.0420 | 0.0420 | 0.0042 | 0.0420 | 0.0425 | 0.0425 | 0.0046 | 0.0428 |
| $\psi_7$ | 0.0420 | 0.0420 | 0.0042 | 0.0420 | 0.0418 | 0.0420 | 0.0047 | 0.0417 |
| $\psi_8$ | 0.0420 | 0.0420 | 0.0042 | 0.0420 | 0.0408 | 0.0408 | 0.0049 | 0.0407 |
| $\psi_9$ | 0.0420 | 0.0420 | 0.0042 | 0.0420 | 0.0393 | 0.0391 | 0.0048 | 0.0396 |
| $\psi_{10}$ | 0.0420 | 0.0420 | 0.0042 | 0.0420 | 0.0377 | 0.0377 | 0.0046 | 0.0377 |

F I G. 15

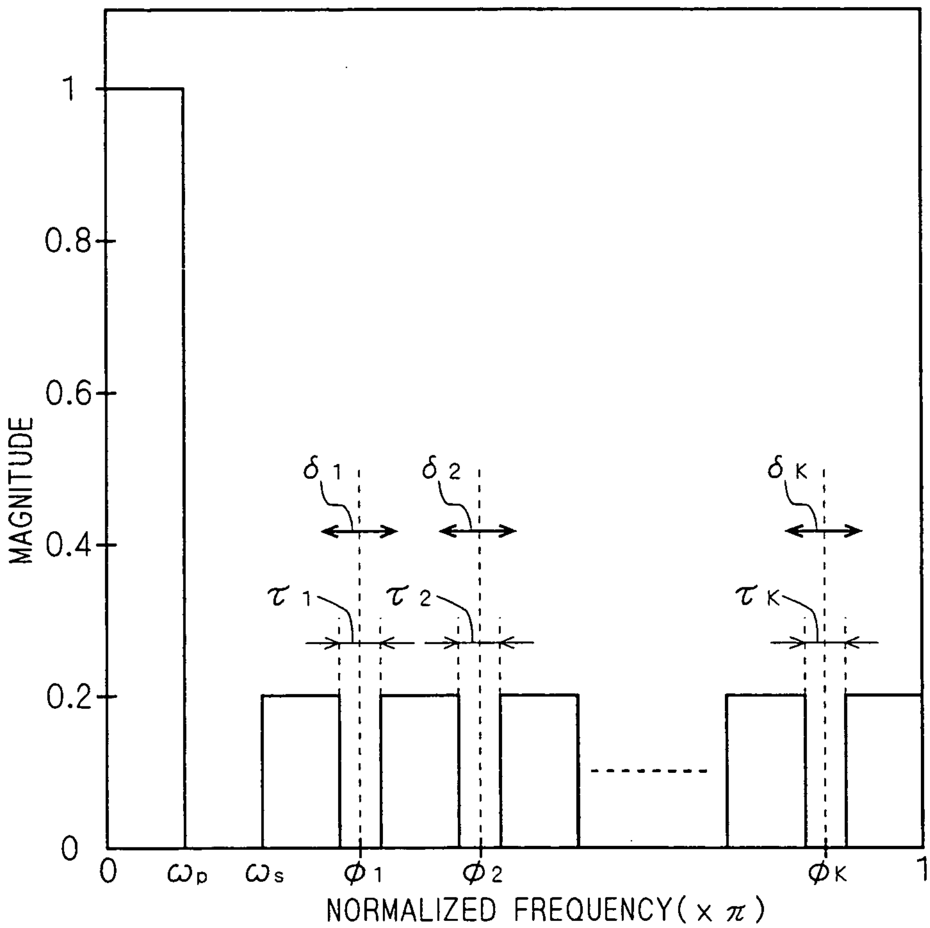
MAGNITUDE
1
0.8
0.6
0.4
0.2
0
δ 1
δ 2
δ K
τ 1
τ 2
τ K
0
ωp
ωs
φ 1
φ 2
φ K
1
NORMALIZED FREQUENCY( x π )

F I G. 16

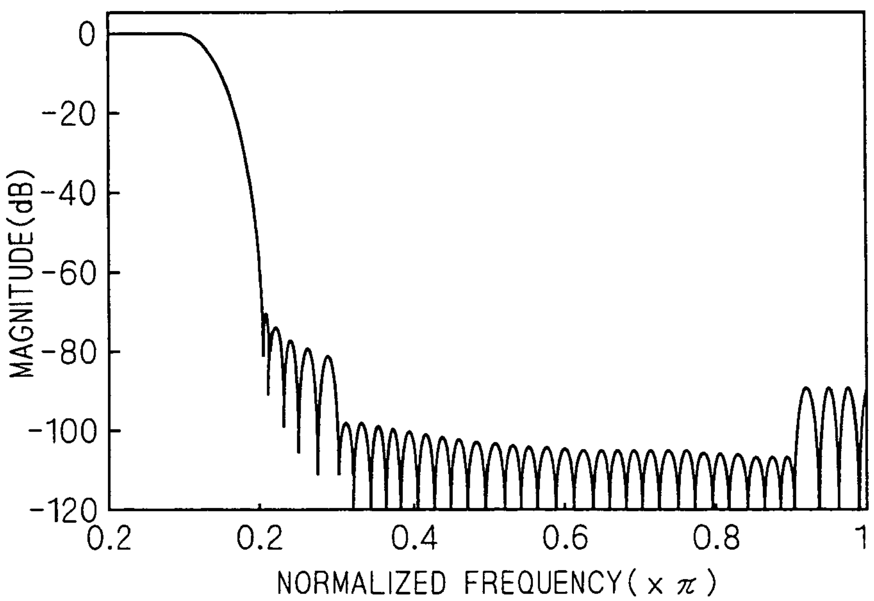
MAGNITUDE(dB)
0
-20
-40
-60
-80
-100
-120
0.2
0.2
0.4
0.6
0.8
1
NORMALIZED FREQUENCY( x π )

FIG. 17

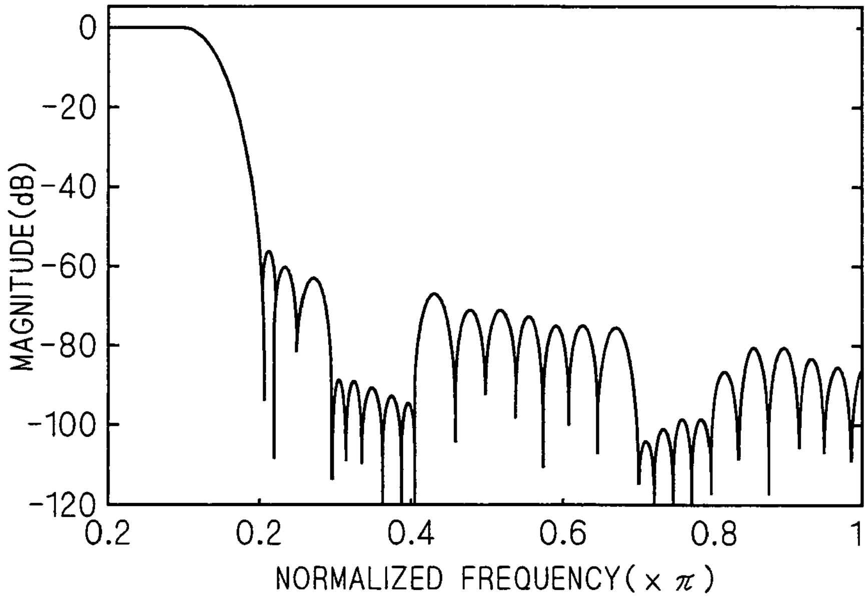


(a) $\delta_1 = -0.05$, $\delta_2 = 0.05$

FIG. 18

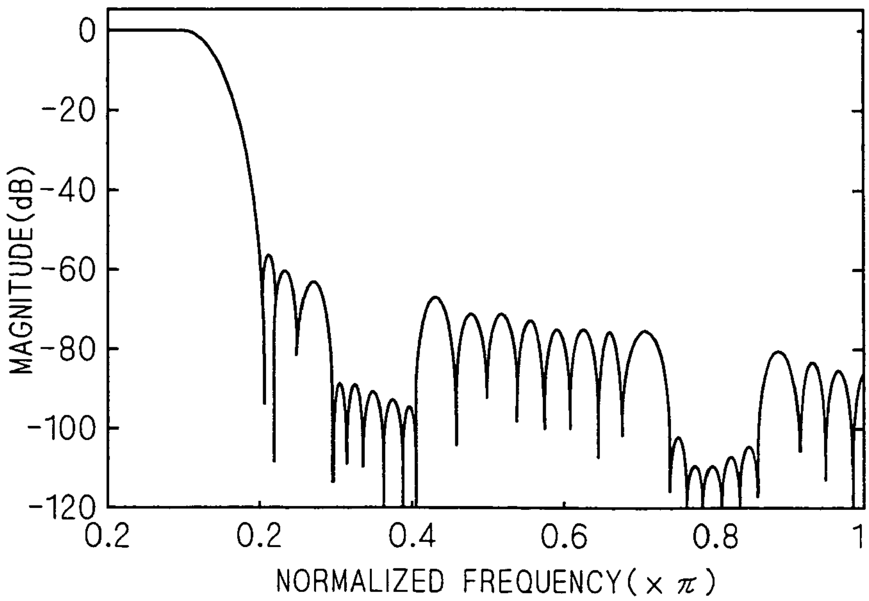


(b) $\delta_1 = -0.05$, $\delta_2 = 0.0$

F I G . 1 9

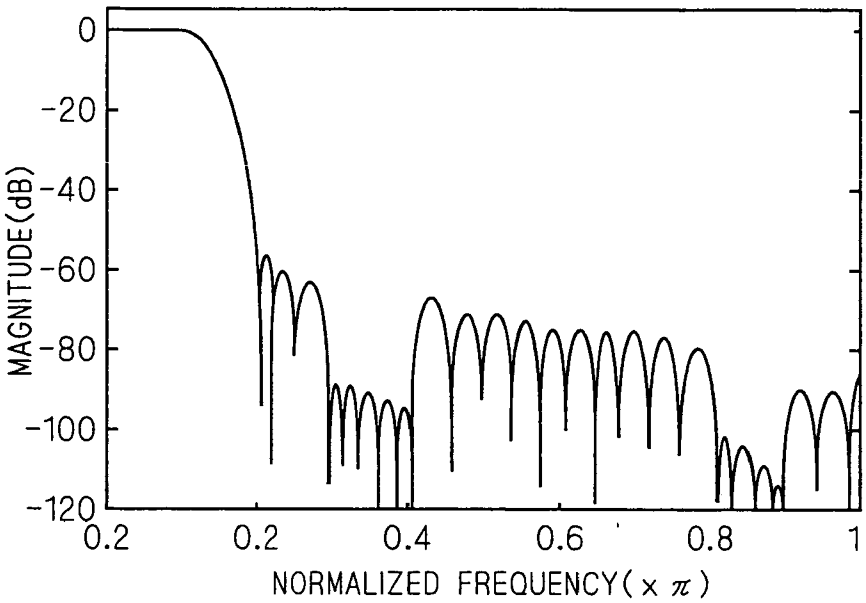


( c ) $\delta_1$=-0.05 , $\delta_2$=0.05

F I G . 2 0

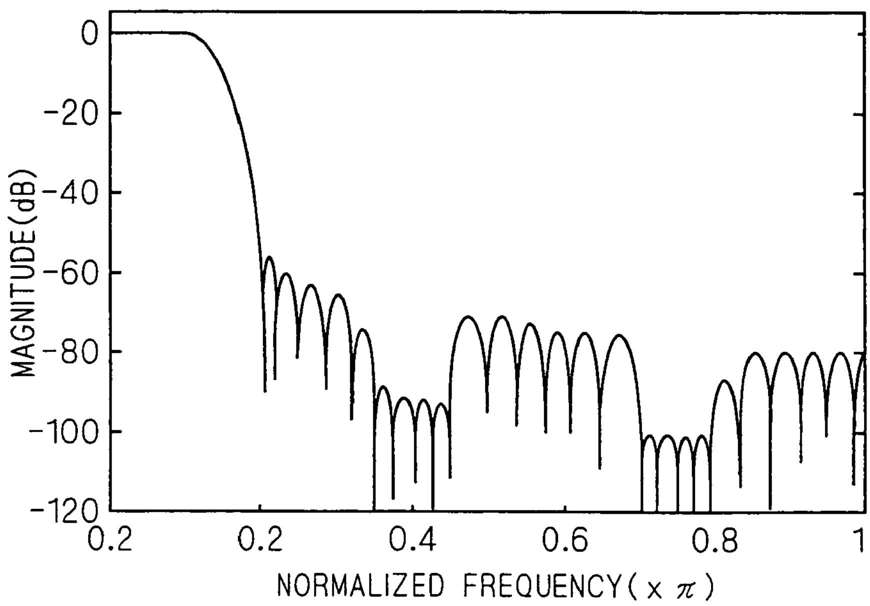


( d ) $\delta_1$=0.0 , $\delta_2$=-0.05

F I G . 2 1

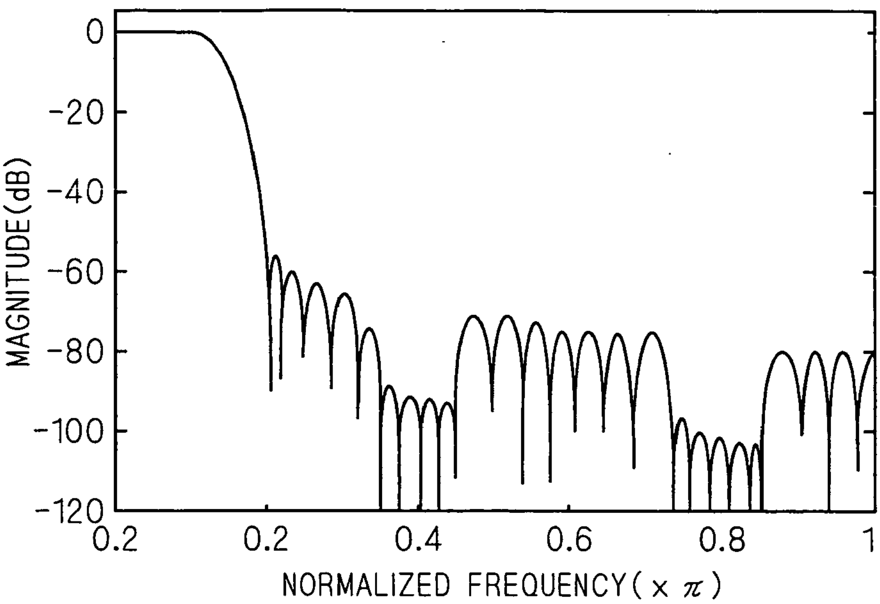


( e ) δ 1=0.0 , δ 2=0.0

F I G . 2 2

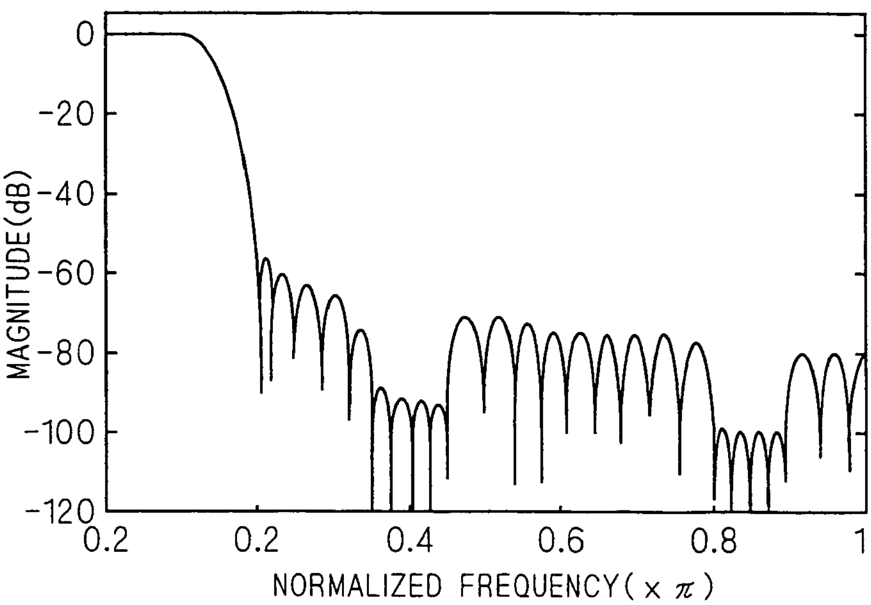


( f ) δ 1=0.0 , δ 2=0.05

FIG. 23

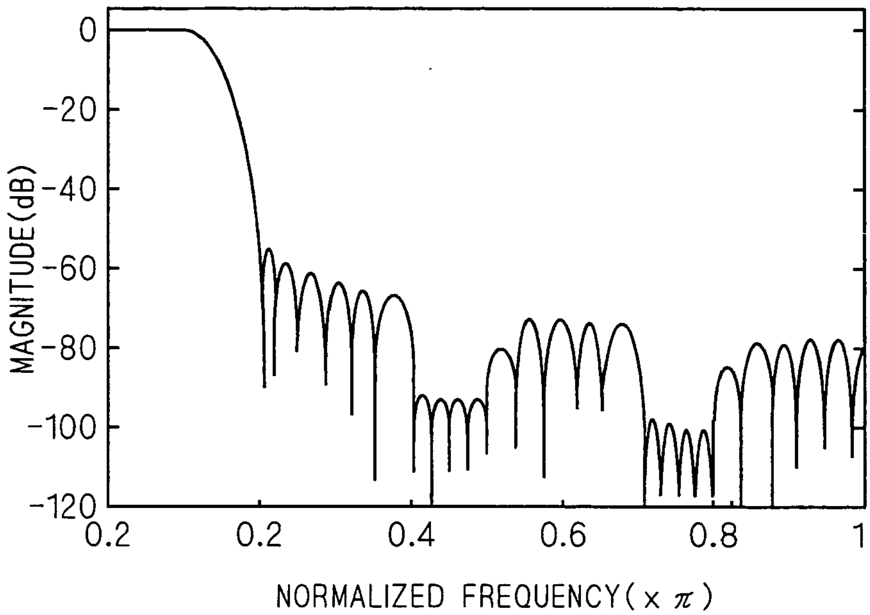


(g) $\delta_1$=0.05, $\delta_2$=-0.05

FIG. 24

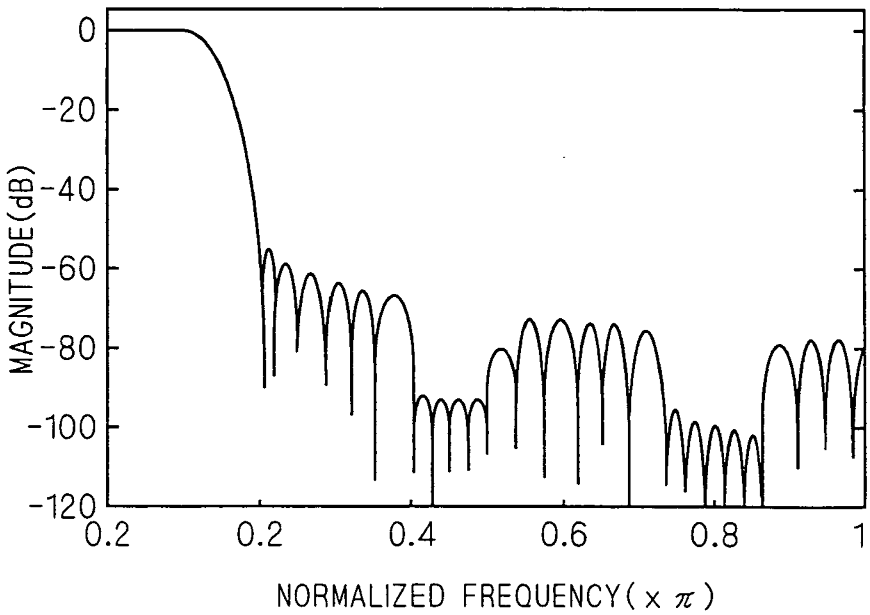


(h) $\delta_1$=0.05, $\delta_2$=-0.05

F I G . 2 5

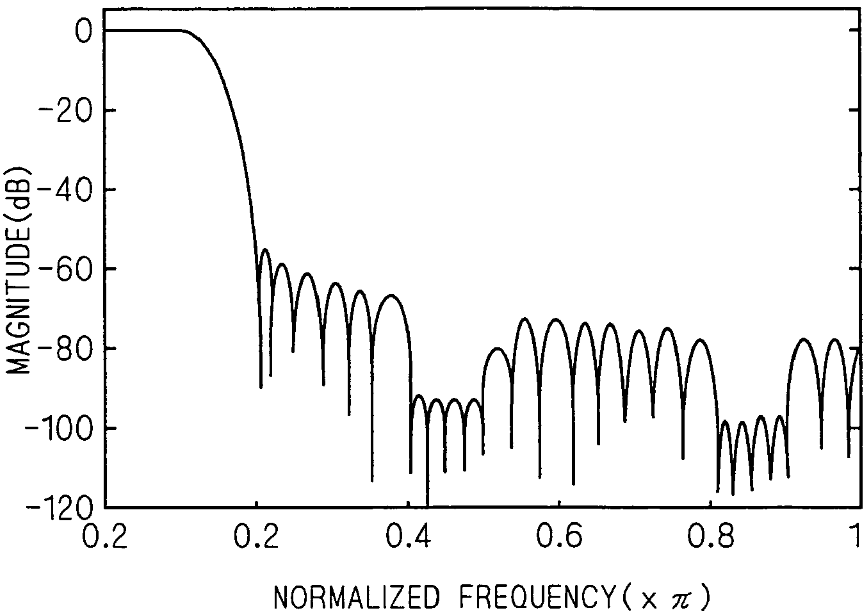


( i ) $\delta_1$=0.05 , $\delta_2$=0.05

F I G . 2 6

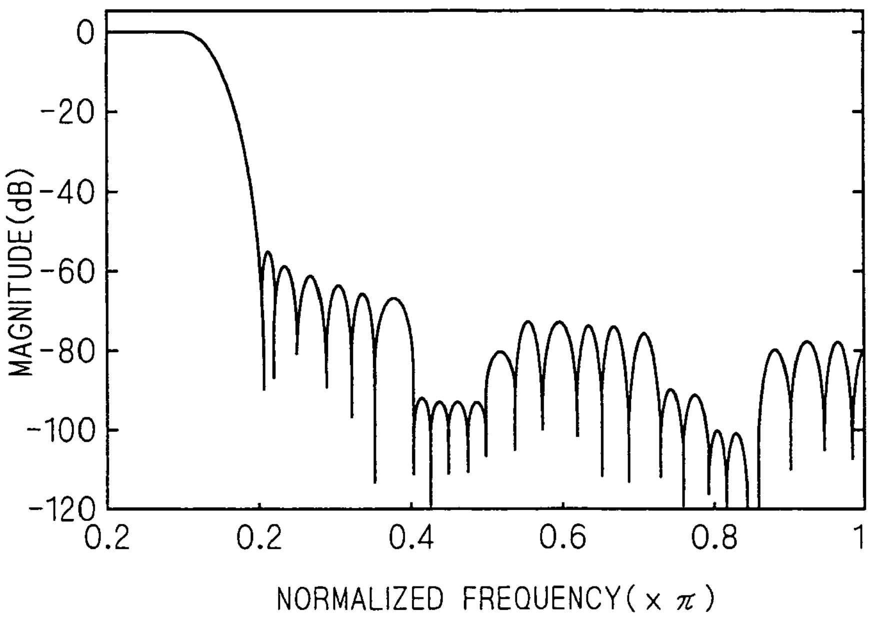


( j ) $\delta_1$=0.05 , $\delta_2$=0.01

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6021814 A
- JP 2004150883 A


### Non-patent literature cited in the description


- **NAOYUKI AIKAWA et al.** Design of FIR Transmitter and Receiver Filters for Data Communication System. *Transaction of IEICE,* March 1996, vol. J79-A (3), 608-615